# EUROPEAN PATENT APPLICATION

(11) **EP 4 534 616 A1**
(43) Date of publication of application: **09.04.2025**
(21) Application number: 23815655.8
(22) Date of filing: 28.04.2023
(51) Int. Cl.: C09D 11/101, C09D 11/322, B41M 5/00, B41J 2/01

(54) **ACTINIC RADIATION-CURABLE INKJET RESIST INK, METHOD FOR FORMING CURED FILM, CURED FILM, PRINTED WIRING BOARD, AND ELECTRONIC DEVICE**

(30) Priority: 30.05.2022 JP 2022087986
(71) Applicant: KONICA MINOLTA, INC., Tokyo 100-7015 (JP)
(72) Inventor: SUGAI, Tomomi, Chiyoda-ku, Tokyo 100-7015 (JP); AOYAMA, Ryo, Chiyoda-ku, Tokyo 100-7015 (JP)
(74) Representative: MFG Patentanwälte Meyer-Wildhagen Meggle-Freund Gerhard PartG mbB
(86) International application number: PCT/JP2023/016799
(87) International publication number: WO 2023/233894

(57) **Abstract**

The ink according to the present invention is an actinic radiation-curable inkjet resist ink comprising an actinic radiation-polymerizable compound (A), a pigment (B), and a pigment dispersant (C), wherein: the pigment (B) contains a red pigment (B1) having a maximum absorption wavelength from 480 nm to 600 nm and a pigment (B2) having a color different from that of the red pigment (B1); the pigment dispersant (C) has an amine value larger than its acid value; the halogen content in the inkjet resist ink is not more than 900 ppm; and the actinic radiation-curable inkjet resist ink substantially does not contain a black inorganic pigment.

## Description

### Technical Field

The present invention relates to an active ray-curable inkjet resist ink, a method for forming a cured film (cured film forming method), a cured film, a printed wiring board, and an electronic device.

### Background Art

A solder resist, which is one of resist inks for industrial use, is an insulating film that covers the surface of a printed wiring board and protects a circuit pattern, and can protect the circuit pattern from dust, heat, moisture, and the like. In addition, when soldering is performed on the substrate, the solder resist repels the solder and can suppress an excessive increase in the area to be soldered.

As resist inks for industrial use for forming solder resists, inks having a reduced halogen content have been proposed in recent years from the viewpoint of reducing the environmental load. For example, PTL 1 proposes an alkaline developable curable resin composition containing a red colorant that is free of halogen and azo groups. Furthermore, PTL 2 proposes an alkaline developable photosolder resist ink containing, in its chemical structural formula, an organic colorant that is free of halogen.

As a method for forming a solder resist, a method using an inkjet printer has been developed. In this method, the ink is applied to the substrate in accordance with a desired pattern, and the applied ink is cured with active rays such as ultraviolet rays to form the solder resist, and therefore, it is considered that the steps of temporary drying, temporary curing using a photomask, and dissolution of an uncured portion with an alkaline aqueous solution can be omitted. Therefore, application of such a method to solder resist formation is expected from the viewpoints of environment consideration and reduction of process load .

Furthermore, in addition to protecting the circuit pattern, the solder resist is required to have discoloration resistance with which a desired tint is stable and color visibility even when exposed to a high-temperature treatment of 200°C or higher in the production process of a printed circuit board or the mounting process onto a printed circuit board. As the color of the solder resist, green is often used because it imposes little burden on human eyes, is excellent in visibility at the time of visual inspection, and is inexpensive in cost, but various colors such as red, blue, and black are sometimes used from the viewpoint of design properties, applications, and the like.

Incidentally, since a substrate on which a solder resist (cured film) is formed is subjected to processing such as soldering for mounting an electronic component on the substrate, the cured film is required to have quality and performance capable of withstanding high-temperature treatment of about 250°C to 290°C. Among these, regarding the color of the cured film, various color variations are required in accordance with customer's demands for ensuring visibility for circuit board quality verification, design properties, making it difficult to read a circuit pattern, and the like. Therefore, it is desired to reduce the color fluctuation of the cured film between before and after a heat treatment such as a soldering step or a plating step. In addition, there is a demand for a active ray -curable inkjet ink capable of forming a cured film that can suppress color fluctuation due to high-temperature treatment.

On the other hand, as an inkjet ink capable of exhibiting various colors, for example, PTL 3 proposes a curable inkjet ink for image formation, which contains a black pigment and at least one type of color pigment.

However, in the formation of a solder resist, more advanced ejection stability is required for forming a precise circuit pattern. Therefore, an inkjet ink suitable for forming a solder resist is required.

### Citation List

### Patent Literature

PTL 1
   Japanese Unexamined Patent Publication No. 2013-101395
PTL 2
   Japanese Unexamined Patent Publication No. 2000-232264
PTL 3
   Japanese Unexamined Patent Publication No. 2005-320541

### Summary of Invention

### Technical Problem

As described above, in order to form a solder resist by an inkjet method, high ejection stability and pigment dispersion stability are required. However, when the technique of the photo solder resist ink as described in PTL 1 or PTL 2 is applied to an inkjet resist ink, the dispersion stability of the pigment after long-term storage is low and is not sufficient.

As a method of enhancing dispersion stability, it is known to use a surface-treated (dispersion-treated) pigment. However, according to the studies of the present inventors, the surface treatment agent often contains a halogen atom, and an increase in the content of the halogen atom causes a problem such that the ejection stability of the ink after long-term storage is lowered.

With respect to the demand for various colors, unlike the production of an image, in the production process of a printed circuit board, there are many heat treatments after film formation, and there is a problem that a pigment is discolored by heat and a desired color cannot be formed. Here, when a pigment having high color fading resistance and shielding power, for example, an inorganic black pigment such as carbon black is used, the exposure sensitivity is lowered, and therefore, there arises a problem that the adhesion of the solder resist film (cured film) to a base material and the heat resistance are not enhanced.

On the other hand, it is desired that the color fluctuation of the cured film is small and the quality is stable before and after heat treatment such as a soldering step and a plating step. Color fluctuation is readily visible when a color material having a maximum absorption wavelength of 480 nm or longer and 600 nm or shorter, which has high luminosity factor for human eyes, is contained. In particular, in the case of black, the hue variation is easily visually recognized. To solve the problem that, in an active ray-curable inkjet ink for inkjet, coating film physical properties and visibility to the color of a cured film are changed by discoloration due to heat before and after high temperature treatment. Therefore, an inkjet resist ink capable of suppressing color fluctuation due to high-temperature treatment is desired.

The present invention has been made in consideration of the above-described circumstances, and an object of the present invention is to provide an active ray-curable inkjet resist ink which can increase the dispersion stability of a pigment and the ejection stability of the ink after long-term storage, which can suppress the color fluctuation of a cured film even after high-temperature treatment, and which can increase the adhesion of the cured film to a base material and the heat resistance of the cured film. Another object of the present invention is to provide a method for forming a cured film using the active ray-curable inkjet resist ink, a cured film, a printed wiring board, and an electronic device.

### Solution to Problem

An aspect of the present invention for solving the above-described problem relates to the following active ray-curable inkjet resist inks [1] to [10].
[1] An active ray-curable inkjet resist ink, containing: an active ray-polymerizable compound (A); a pigment (B); and a pigment dispersing agent (C), wherein
   the pigment (B) includes a red pigment (B1) having a maximum absorption wavelength of 480 nm or more and 600 nm or less and a pigment (B2) having a color different from that of the red pigment (B1); the pigment dispersing agent (C) has an amine value and an acid value, the amine value being larger than the acid value; and a halogen content in the active ray-curable inkjet resist ink is 900 ppm or less, and the active ray-curable inkjet resist ink is substantially free of a black inorganic pigment.
[2] The active ray-curable inkjet resist ink according to [1], further containing a synergist (D).
[3] The active ray-curable inkjet resist ink according to [1] or [2], wherein a content of the black inorganic pigment is less than 0.01% by mass.
[4] The active ray-curable inkjet resist ink according to any one of [1] to [3], wherein: the active ray-polymerizable compound (A) includes a compound (A1) having a ClogP value of 4.0 or more and 7.0 or less, and a content of the compound (A1) is 10% by mass or more and 50% by mass or less based on a total mass of the active ray-curable inkjet resist ink.
[5] The active ray-curable inkjet resist ink according to [4], wherein the compound (A1) has a molecular weight of 300 or more and 1500 or less.
[6] The active ray-curable inkjet resist ink according to any one of [1] to [5], wherein the active ray-polymerizable compound (A) includes a compound having three or more polymerizable groups.
[7] The active ray-curable inkjet resist ink according to any one of [1] to [6], wherein the active ray-polymerizable compound (A) includes a compound represented by a general formula (1) below or a salt thereof: 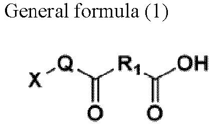 in the general formula (1), R1 represents an unsubstituted alkylene group having 1 to 6 carbon atoms, Q represents an oxygen atom or NR2, R2 represents a hydrogen atom, a substituted or unsubstituted alkyl group, or a substituted or unsubstituted aryl group, and X represents a structure derived from an alcohol or an amine and having at least one polymerizable group selected from the group consisting of a (meth)acryloyl group, an aryl group, and a vinyl group at a terminal of the structure.
[8] The active ray-curable inkjet resist ink according to any one of [1] to [7], further containing a gelling agent (E).
[9] The active ray-curable inkjet resist ink according to [8], wherein the active ray-curable inkjet resist ink has a viscosity of 1.0 Pa·s or more and 1.0 × 10⁴ Pa·s or less at a temperature of 25°C, and undergoes a sol-gel phase transition at a temperature of 40°C or more and less than 100°C.
[10] The active ray-curable inkjet resist ink according to any one of [1] to [9], wherein
   the halogen content in the active ray-curable inkjet resist ink is 300 ppm or less.
   In addition, an aspect of the present invention for solving the above problems relates to the following methods for forming the following cured films [11] and [12].
[11] A method for forming a cured film, the method including: applying the active ray -curable inkjet resist ink according to any one of [1] to [10] onto a printed wiring board; and irradiating the applied active ray-curable inkjet resist ink with an active ray.
[12] The method according to [11], further including: heating to cure the active ray -curable inkjet resist ink having been irradiated with the active ray.
   One embodiment of the present invention for solving the above problems relates to the following cured film [13].
[13] A cured film obtained by curing the active ray-curable inkjet resist ink according to any one of [1] to [10].
   One embodiment of the present invention for solving the above problems relates to the following printed wiring board [14].
[14] A printed wiring board including the cured film according to [13].
   Another embodiment of the present invention for solving the above problems relates to the following electronic device [15].
[15] An electronic device including the printed wiring board according to [14].

### Advantageous Effects of Invention

The present invention provides an active ray-curable inkjet resist ink which can increase the dispersion stability of a pigment and the ejection stability of the ink after long-term storage, which can suppress the color fluctuation of a cured film even after high-temperature treatment, and which can increase the adhesion of the cured film to a base material and the heat resistance of the cured film. The present invention also provides a method for forming a cured film using the active ray-curable inkjet resist ink, a cured film, a printed wiring board, and an electronic device.

### Description of Embodiments

Hereinafter, an embodiment of the present invention will be described in detail. Note that the present invention is not limited to the following forms.

### 1. Active ray-curable inkjet resist ink

The active ray-curable inkjet resist ink according to the present embodiment (hereinafter, also simply referred to as ink) contains an active ray-polymerizable compound (A), a pigment (B) and a pigment dispersing agent (C), and the halogen content in the inkjet resist ink is 900 ppm or less. The ink according to the present embodiment can be used for various resists (e.g., solder resist).

As described above, when a pigment subjected to surface treatment (dispersion treatment) is used in an ink in an attempt to enhance the dispersion stability, there has been a problem that the ejection stability of the ink during long-term storage decreases, depending on the content of the pigment.

The present inventors have investigated the cause of the problem and found that the use of the surface-treated pigment described above tends to increase the halogen content in the ink. It is considered that when the halogen content in the ink increases, metal ions such as calcium ions contained in the ink in the process of the preparation of the ink react with halide ions, so that an inorganic salt tends to be precipitated. It is considered that due to the precipitation of the inorganic salt, the ejection stability of the ink is lowered.

Therefore, the present inventors have conducted intensive studies and found that for an ink in which the type and amount of pigment used are adjusted so that the halogen content is 900 ppm or less, the use of a pigment dispersing agent having an amine value that is higher than the acid value can enhance the dispersion stability while inhibiting a reduction in ejection stability.

It is considered that the pigment dispersing agent tends to interact with the pigment. It is considered that when this pigment dispersing agent is contained in an ink having a halogen content of 900 ppm or less, the halide ion or the inorganic salt in the ink can be prevented from inhibiting the adsorption between the pigment dispersing agent and the pigment, and thus the dispersion stability can be enhanced. In addition, it is considered that since the dispersibility of the pigment can be increased even after the ink has been stored for a long period of time, the ejection stability of the ink after long-term storage can also be increased.

Furthermore, the present inventors have found that even when a red pigment having high luminosity factor for human eyes is used, the color fluctuation due to high-temperature treatment or the like is significantly improved according to the present invention.

In addition, since the ink is substantially free of a black pigment, it is possible to suppress the black pigment from absorbing active rays and to promote the polymerization of the active ray-polymerizable compound. Thus, the adhesion of the cured film to the base material and the heat resistance can be enhanced.

### 1-1. Active ray-polymerizable compound (A)

The active ray-polymerizable compound (A) contained in the ink according to the present embodiment is a compound which is polymerized and crosslinked by irradiation with active rays. In the present embodiment, the active ray-polymerizable compound (A) may be a compound which is polymerized and crosslinked by heating.

Examples of the active rays include electron beams, ultraviolet rays, α-rays, γ-rays, and X-rays. Among these, ultraviolet rays and electron beams are preferable, and ultraviolet rays are more preferable.

The number of polymerizable groups contained in the active ray-polymerizable compound (A) may be one (monofunctional) or two or more (polyfunctional). From the viewpoint of further enhancing the adhesion of the cured film formed by the active ray-curable inkjet resist ink to the substrate and the heat resistance of the cured film, the active ray-polymerizable compound (A) preferably contains a compound having two or more polymerizable groups, and more preferably contains a compound having three or more polymerizable groups. The number of polymerizable groups in the active ray-polymerizable compound is preferably 30 or less.

The content of the compound having two polymerizable groups is preferably 15% by mass or more and 80% by mass or less based on the total mass of the active ray-polymerizable compound (A). In addition, the content of the compound having three or more polymerizable groups is preferably 5% by mass or more and 70% by mass or less based on the total mass of the active ray-polymerizable compound (A).

The active ray-polymerizable compound (A) is preferably a radically polymerizable compound. The radically polymerizable compound is a compound (a monomer, an oligomer, a dendrimer, or a mixture thereof) having a radically polymerizable ethylenically unsaturated bond. Only one type of radically polymerizable compound may be contained in the ink or two or more types thereof may be contained in combination.

Examples of the radically polymerizable compound include unsaturated carboxylic acid esters and (meth)acrylates. Of these, (meth)acrylates are preferred.

Examples of the monofunctional (meth)acrylate include isoamyl acrylate, stearyl acrylate, lauryl acrylate, octyl acrylate, decyl acrylate, isomyristyl acrylate, isostearyl acrylate, 2-ethylhexyl-diglycol acrylate, 2-acryloyloxyethylhexahydrophthalic acid, butoxyethyl acrylate, ethoxydiethylene glycol acrylate, methoxydiethylene glycol acrylate, methoxypolyethylene glycol acrylate, methoxypropylene glycol acrylate, phenoxyethyl acrylate, o-phenylphenol acrylate, nonylphenol acrylate, 2-hydroxy-3-phenoxypropyl acrylate, cumylphenoxylethyl acrylate, tetrahydrofurfuryl acrylate, isobornyl acrylate, 2-hydroxyethyl acrylate, 2-hydroxypropyl acrylate, 2-hydroxybutyl acrylate, 2-acryloyloxyethylsuccinic acid, 2-acryloyloxyethylphthalic acid, 2-acryloyloxyethyl-2-hydroxyethyl-phthalic acid, and t-butylcyclohexyl acrylate.

Of the aforementioned monofunctional (meth)acrylates, phenoxyethyl acrylate, o-phenylphenol acrylate and 2-hydroxy-3-phenoxypropyl acrylate are preferable from the viewpoint of suppressing curing shrinkage.

Examples of the bifunctional (meth)acrylate include triethylene glycol di(meth)acrylate, tetraethylene glycol di(meth)acrylate, polyethylene glycol di(meth)acrylate, dipropylene glycol di(meth)acrylate, tripropylene glycol di(meth)acrylate, polypropylene glycol di(meth)acrylate, 1,4-butanediol di(meth)acrylate, 1,6-hexanediol di(meth)acrylate, 1,9-nonanediol di(meth)acrylate, neopentyl glycol di(meth)acrylate, PO adduct di(meth)acrylate of bisphenol-A, hydroxypivalate neopentyl glycol di(meth)acrylate, polytetramethylene glycol di(meth)acrylate, and tricyclodecanedimethanol di(meth)acrylate.

Among the above-described bifunctional (meth)acrylates, from the viewpoint of accelerating the curing of the ink, neopentyl glycol diacrylate, tricyclodecane dimethanol diacrylate, PO adduct diacrylate of bisphenol A, and hydroxypivalic acid neopentyl glycol diacrylate are preferable.

Examples of the (meth)acrylate having three or more functional groups include trimethylolpropane tri(meth)acrylate, pentaerythritol tri(meth)acrylate, pentaerythritol tetra(meth)acrylate, dipentaerythritol hexa(meth)acrylate, ditrimethylolpropane tetra(meth)acrylate, glycerolpropoxy tri(meth)acrylate, and pentaerythritol ethoxy tetra(meth)acrylate.

The (meth)acrylate may be, for example, acrylates modified with an alkylene oxide such as ethylene oxide (EO) or propylene oxide (PO), or caprolactone (modified (meth)acrylate). Examples of the modified (meth)acrylate include caprolactone-modified acrylates such as o-phenylphenol EO-modified (meth)acrylate, EO-modified trimethylolpropane tri(meth)acrylate, EO-modified pentaerythritol tetra(meth)acrylate, EO-modified hexanediol di(meth)acrylate, PO-modified trimethylolpropane tri(meth)acrylate, PO-modified pentaerythritol tetra(meth)acrylate, nonylphenol PO-modified (meth)acrylate, propoxylated neopentyl glycol di(meth)acrylate, propoxylated trimethylolpropane tri(meth)acrylate, and caprolactone-modified trimethylolpropane tri(meth)acrylate, and caprolactam-modified dipentaerythritol hexa(meth)acrylate.

The active ray-polymerizable compound preferably includes a compound having a cyclic structure, from the viewpoint of further improving the heat resistance of a cured film.

The (meth)acrylate may be a polymerizable oligomer. Examples of the (meth)acrylate that is a polymerizable oligomer include an epoxy (meth)acrylate oligomer, a urethane (meth)acrylate oligomer, a polyester (meth)acrylate oligomer, and a linear (meth) acrylic oligomer. Among these, the polymerizable oligomer is preferably a urethane (meth)acrylate oligomer.

According to the finding of the present inventors, in the urethane acrylate oligomer, polymerization easily proceeds, and a crosslinked structure is easily formed by a hydrogen bond between urethane bonds. Therefore, when the ink contains the urethane acrylate oligomer, it is possible to further increase the fastness of the cured film formed by the ink and the adhesion to a base material.

The urethane acrylate oligomer is obtained, for example, by reacting an isocyanate with an acrylic acid derivative having a hydroxy group.

Examples of the isocyanate as a starting material for the urethane acrylate oligomer include isophorone diisocyanate, 2,4-tolylene diisocyanate, 2,6-tolylene diisocyanate, hexamethylene diisocyanate, trimethylhexamethylene diisocyanate, diphenylmethane-4,4'-diisocyanate (MDI), hydrogenated MDI, polymeric MDI, 1,5-naphthalene diisocyanate, norbornane diisocyanate, tolidine diisocyanate, xylylene diisocyanate (XDI), hydrogenated XDI, lysine diisocyanate, triphenylmethane triisocyanate, tris(isocyanatophenyl) thiophosphate, tetramethylxylene diisocyanate, and 1,6,10-undecane triisocyanate.

Examples of the acrylic derivative having a hydroxy group as a starting material for the urethane acrylate oligomer include hydroxyalkyl (meth)acrylates such as 2-hydroxyethyl acrylate, 2-hydroxypropyl acrylate, 4-hydroxybutyl acrylate and 2-hydroxybutyl acrylate, monoacrylates of dihydric alcohols such as ethyleneglycol, propyleneglycol, 1,3-propanediol, 1,3-butanediol, 1,4-butanediol and polyethyleneglycol, monoacrylates or diacrylates of trihydric alcohols such as trimethylolethane, trimethylolpropane and glycerin, and epoxy acrylates such as bisphenol A-type epoxy acrylate.

The polymerizable oligomer may be an acrylate oligomer having a hyperbranched structure or a dendrimer structure. When the acrylate oligomer has such a structure, a polymerization reaction easily proceeds and a crosslinked structure is easily formed. Therefore, the fastness and the heat resistance of the cured film can be further improved.

An example of a commercially available acrylate oligomer having a hyperbranched structure or a dendrimer structure is v #1000 (dendrimer structure, manufactured by Osaka Organic Chemical Industry Ltd), CN2302, CN2303, CN2304, (hyperbranched structure), all manufactured by Sartomer), SP1106 (dendrimer structure, miwon), ETERCURE6361-100, ETERCURE6363 (hyperbranched structure, all manufactured by Nagiko Chemical Industry Co., Ltd). Only one of these may be contained in the ink, or two or more of these may be contained in combination.

The active ray-polymerizable compound (A) preferably includes a compound represented by general formula (1) or a salt thereof.

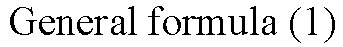

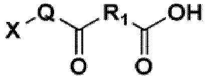

In the general formula (1), R₁ represents an unsubstituted alkylene group having 1 or more and 6 or less carbon atoms, Q represents an oxygen atom or NR₂, R₂ represents a hydrogen atom, a substituted or unsubstituted alkyl group, or a substituted or unsubstituted aryl group, and X represents a structure derived from an alcohol or an amine and having at least one polymerizable group selected from the group consisting of a (meth)acryloyl group, an aryl group, and a vinyl group at the terminal of the structure.

The compound in which the active ray-polymerizable compound is represented by general formula (1) has a structure derived from a dicarboxylic acid, and therefore can increase the affinity of the ink for a base material and further increase the adhesion of the cured film to be formed to the base material.

From the viewpoint of further enhancing the adhesion of a cured film to a base material, R₁ is preferably an unsubstituted alkylene group having 1 or 2 carbon atoms.

From the viewpoint of further enhancing the adhesion of the cured film to the base material, Q is preferably an oxygen atom.

From the viewpoint of further enhancing the adhesion of the cured film to the base material, the polymerizable group at the terminal of X preferably includes a (meth) acryloyl group. From the viewpoint of further improving the ejection stability of the ink, the total number of carbon atoms in X is preferably 50 or less, and more preferably 30 or less.

The content of the compound represented by general formula (1) is preferably 1% by mass or more and 50% by mass or less, more preferably 3% by mass or more and 20% by mass or less, based on the total mass of the ink. When the vapor content is within the above range, the adhesion of the cured film to the base material can be further improved.

Examples of the compound represented by the general formula (1) include the following compounds.

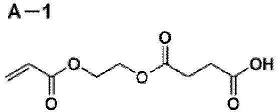

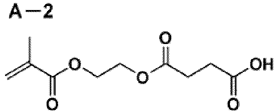

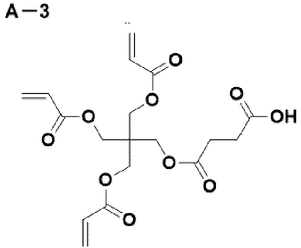

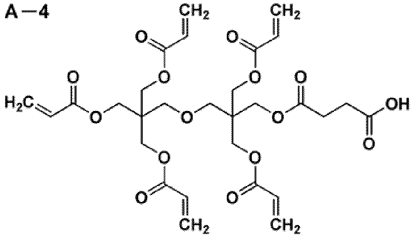

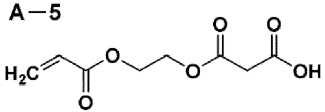

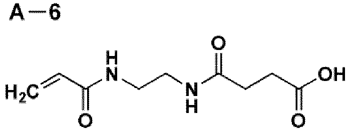

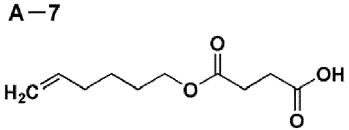

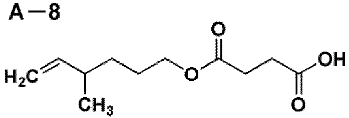

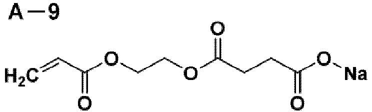

In the present embodiment, the active ray-polymerizable compound (A) preferably includes a compound (A1) having a ClogP value of 4.0 or more and 7.0 or less. Preferably, compound (A1) is monomeric and free of oligomers and dendrimers.

The "logP value" is an index indicating the hydrophobicity (hydrophilicity) of a compound. Specifically, it is a logarithmic value of the 1-octanol/water partition coefficient P. That is, as the logP value is larger, the compound is more likely to be hydrophobic.

The "CLogP value" is an estimated value of a LogP value calculated by using a fragment method or the like. More specifically, the CLogP value can be calculated using the fragment method described in the literature (C. Hansch and A. Leo, "Substituent Constants for Correlation Analysis in Chemistry and Biology" (John Wiley & Sons, New York, 1969)) or using the commercially available software packages 1 or 2 described below.
Software package 1: MedChem Software (Release 3.54, August 1991, Medicinal Chemistry Project, Pomona College, Claremont, CA)
Software package 2: Chem Draw Ultra ver. 8.0. (April 2003, CambridgeSoft Corporation, USA)

The ClogP value described in the present specification is a value calculated using the software package 2 described above.

When the ClogP value of the compound (A1) is 4.0 or more, the compound (A1) becomes more hydrophobic, and the water resistance of the cured film to be formed is further enhanced. In addition, according to the findings of the present inventors, when the ClogP value of the compound (A1) is 7.0 or less, it is possible to suppress the hydrophobicity of the ink from being excessively increased, to suppress the precipitation of the inorganic salt due to halogen, and to further improve the ejection stability.

Examples of the compound (A1) having a ClogP value of 4.0 or more and 7.0 or less include: propoxylated (3) neopentyl glycol diacrylate (molecular weight: 470, ClogP value: 4.90), 1,10-decanediol dimethacrylate (molecular weight: 310, ClogP value: 5.75), tricyclodecane dimethanol diacrylate (molecular weight: 304, ClogP value: 4.69) and tricyclodecane dimethanol dimethacrylate (molecular weight: 332, ClogP value: 5.12), dipentaerythritol hexaacrylate (molecular weight: 578, ClogP value: 5.08), and the like. The active ray-polymerizable compound (A) may contain only one type of compound (A1), or may contain two or more types of compounds (A1) in combination.

The molecular weight of the compound (A1) is preferably 300 or more and 1500 or less. When the molecular weight of the compound (A1) is 300 or more, the liquid component of the ink is less likely to volatilize. According to this, it is possible to further suppress a decrease in ejection stability due to drying of the ink attached to the nozzle of the inkjet head and fixing of a non-volatile component such as a pigment included in the ink to the nozzle. When the value is 1500 or less, it is possible to suppress the viscosity of the ink from being excessively increased, and to suppress a decrease in ejection stability. From such a viewpoint, the molecular weight is more preferably 300 or more and 1,000 or less, and still more preferably 300 or more and 800 or less.

When the active ray-polymerizable compound (A) includes the compound (A1), the content of the compound (A1) is preferably 10% by mass or more and 50% by mass or less, and more preferably 15% by mass or more and 45% by mass or less, based on the total mass of the ink. When the content is within the above range, the water resistance and the ejection stability of the cured film can be further improved.

From the viewpoint of further suppressing a decrease in the ejection stability, the content of the compound having a ClogP value of 7.0 or more is preferably less than 30% by mass, more preferably less than 10% by mass, and still more preferably less than 1% by mass, based on the total mass of the ink.

Note that in the present specification, the content of the compound having two polymerizable groups, the content of the compound having three or more polymerizable groups, the content of the compound represented by general formula (1), and the content of the compound (A1) are each independent amounts.

The content of the active ray-polymerizable compound (A) can be, for example, 1% by mass or more and 99% by mass or less, preferably 30% by mass or more and 99% by mass or less, and more preferably 50% by mass or more and 95% by mass or less, based on the total mass of the ink.

### 1-2. Pigment (B).

The pigment (B) contained in the ink according to the present embodiment include a red pigment (B1) having a maximum absorption wavelength of 480 nm or more and 600 nm or less, and a pigment (B2) having a color different from that of the red pigment (B1).

### 1-2-1. Red Pigment (B1)

The red pigment (B1) is a pigment having a maximum absorption wavelength of 480 nm or more and 600 nm or less. As described above, since the ink according to the embodiment includes the red pigment (B1), it is possible to suppress a change in visibility with respect to the color of the cured film.

Examples of the red pigments (B1) include Pigment Red (PR) 3, 5, 19, 22, 31, 38, 43, 48:1, 48:2, 48:3, 48:4, 48:5, 49:1, 53:1, 57:1, 57:2, 58:4, 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, 257, Pigment Violet (PV) 3, 19, 23, 29, 30, 37, 50, 88, Pigment Orange (PO) 13, 16, 20, 36, and the like. The red pigment (B1) may be a mixture of these.

Among these, PR 122, PV19, and PR 149 are preferable from the viewpoint of facilitating adjustment of the halogen content in the ink to the above-described range. The content of these pigments is preferably 85% by mass to 100% by mass, and more preferably 95% by mass to 100% by mass, based on the total mass of the red pigment (B1).

The content of the red pigment (B1) can be, for example, 0.1% by mass or more and 20% by mass or less, preferably 1.0% by mass or more and 15.0% by mass or less, and more preferably 1.0% by mass or more and 10.0% by mass or less based on the total mass of the ink, from the viewpoint of further suppressing the color fluctuation of the cured film.

### 1-2-2. Pigment (B2) of color different from red pigment

The pigment (B2) is a pigment having a color different from that of the red pigment. In the present specification, the term "color different from that of a red pigment" refers to a pigment having a maximum absorption wavelength outside the range of 480 nm or more and 600 nm or less. The pigment (B2) is preferably a pigment having a clear peak of absorbance in the visible light region outside the range of wavelengths from 480 nm to 600 nm. Examples of the pigment (B2) include a yellow pigment and a blue pigment. The pigment (B2) may contain only one type thereof, or may contain two or more types thereof in combination.

Examples of the yellow pigments include Pigment Yellow (PY) 1, 3, 12, 13, 14, 17, 34, 35, 37, 55, 74, 81, 83, 93, 94, 95, 97, 108, 109, 110, 137, 138, 139, 153, 154, 155, 157, 166, 167, 168, 180, 185, 193, and the like. The yellow pigment may be a mixture of these.

Examples of the blue pigments include Pigment Blue (PB) 1, 15, 15:1, 15:2, 15:3, 15:4, 15:6, 16, 17:1, 22, 27, 28, 29, 36, 60, and the like. The blue pigment may be a mixture of these. According to the finding of the present inventors, the blue pigment is more easily dispersed in the ink.

The content of the pigment (B2) can be, for example, 0.1% by mass or more and 20% by mass or less.

The total content of the red pigment (B1) and the pigment (B2) is preferably 0.1% by mass or more and 20% by mass or less based on the total mass of the ink. The red pigment (B1) may be contained in an amount of 0.1% by mass or more and 19.9% by mass based on the total mass of the ink, and the pigment (B2) may be contained in an amount of 0.1% by mass or more and 19.9% by mass based on the total mass of the ink.

The ink according to the present embodiment is substantially free of a black pigment. In the present specification, "being substantially free of a black inorganic pigment" means that the content of the black pigment based on the total mass of the ink is less than 0.01% by mass. The content of the black inorganic pigment is preferably less than 0.001 mass% and more preferably less than 0.0001 mass% based on the total mass of the ink.

According to the findings of the present inventors, when a pattern of a solder resist is formed with an ink containing a black inorganic pigment, even when heat is applied to the cured film, discoloration is less likely to occur. However, on the other hand, when the ink is cured, the black inorganic pigment absorbs active rays, polymerization of the active ray-polymerizable compound in the ink does not proceed sufficiently, and the adhesion and the heat resistance of the cured film are more likely to decrease. Therefore, when the content of the black inorganic pigment is less than 0.01% by mass, a decrease in the adhesion and the heat resistance of the cured film can be suppressed.

In the ink according to the present embodiment, the volume-average particle diameter of the pigment (B) is not particularly limited, but is preferably 0.08 µm or more and 0.5 µm or less. The particle size of the pigment particle refers to a particle size of a pigment particle in a state where a pigment dispersing agent (C) described below adheres thereto. When the volume average particle diameter is within the above range, the ejection stability can be further enhanced while the dispersibility of the pigment is further enhanced. The volume average particle diameter can be determined with a known particle diameter measuring instrument using a dynamic light scattering method or an electrophoresis method.

### 1-3. Pigment dispersing agent (C)

The pigment dispersing agent (C) included in the ink according to the present embodiment has an amine value that is greater than an acid value, and the acid value is less than or equal to 20 mg/KOH. As described above, the use of such a pigment dispersing agent (C) can improve the dispersion stability of the ink.

Examples of the pigment dispersing agent (C) include BYK-JET-9151 (manufactured by Byk-Chemie GmbH) and EFKA7701 (manufactured by BASF). Only one type of the pigment dispersing agent (C) may be contained in the ink, or two or more types thereof may be contained in combination.

The acid value of the pigment dispersing agent (C) is preferably 20 mg/KOH or less, and more preferably 10 mg/KOH or less. The lower limit of the acid value is not particularly limited and can be set to 0 mg/KOH or more.

The amine value of the pigment dispersing agent (C) is not particularly limited as long as it is larger than the acid value, but is preferably 10 mg/KOH or more, and more preferably 20 mg/KOH or more, from the viewpoint of further enhancing the ink dispersion stability. The upper limit of the amine value is not particularly limited, but can be, for example, 60 mg/KOH or lower.

Furthermore, from the viewpoint of further enhancing the dispersion stability of the ink, the difference between the amine value and the acid value of the pigment dispersing agent (C) is preferably 1 mg/KOH or more and 40 mg/KOH or less, more preferably 10 mg/KOH or more and 40 mg/KOH or less.

The acid value and the amine value can be measured by a potentiometric titration method. For example, the values can be measured by the method described in Journal of the Society of Coloring Materials, 61, [12] 692 to 698 (1988).

The acid value can be determined from the amount of a 0.01 mol/L solution of potassium methoxide-methyl isobutyl ketone/methanol (volume ratio 4:1) required for neutralization when a solution obtained by dissolving 1 g of the pigment dispersing agent (C) in 100 mL of methyl isobutyl ketone (MIBK) is subjected to potentiometric titration with the potassium methoxide-methyl isobutyl ketone/methanol solution.

The amine value can be obtained from the amount of a 0.01 mol/L solution of methyl isobutyl ketone (MIBK) perchlorate required for neutralization when a solution obtained by dissolving 1 g of the pigment dispersing agent (C) in 100 mL of MIBK is subjected to potentiometric titration with the MIBK perchlorate solution.

The content of the pigment dispersing agent (C) can be, for example, 1% by mass or more and 95% by mass or less, is preferably 10% by mass or more and 70% by mass or less, and more preferably 30% by mass or more and 45% by mass or less based on the total mass of the pigment (B). When the content of the pigment dispersing agent (C) is 10 mass% or more, the dispersion stability of the ink can be further improved.

### 1-4. Synergist (D)

The ink according to the present embodiment may contain a synergist (D).

The synergist (D) is a compound having an anchor portion that adsorbs to the pigment (B) and a polar portion that adsorbs to a pigment dispersing agent. In the ink, the anchor portion of the synergist (D) adsorbs to the pigment, and the polar portion of the synergist (D) adsorbs to the pigment dispersing agent (C). Therefore, the pigment dispersing agent (C) can be attached to the pigment via the synergist (D) and is not easily dissociated from the pigment. Thus, the dispersion stability of the ink can be further improved. In particular, when the B2 is a Y pigment, use of a synergist for dispersion can further improve the dispersion stability of the ink.

Furthermore, as a result of investigations by the present inventors, when the amine value of the pigment dispersing agent (C) contained in the ink is higher than the acid value thereof, the inclusion of the synergist (D) can significantly increase the dispersion stability of the ink.

Examples of synergists include pigment derivatives. The pigment derivative is a compound obtained by introducing a polar group into a pigment serving as a mother nucleus. That is, in the pigment derivative, the pigment serving as a mother nucleus serves as an anchor portion, and the polar group serves as a polar portion.

Examples of the polar group include chlorine group, sulfonyl group, sulfonylamide group, carboxyl group, carboxylamide group, amino group, amide group, aminomethyl group, imide group, imidomethyl group, phthalimide group, phthalimidomethyl group, nitro group, cyano group, and phosphate group. Of these, carboxyl, sulfonyl, nitro, phosphate, amino, and amide groups are preferred.

Examples of the pigment derivative include an azo derivative, a quinoline derivative, and a pyrazole derivative.

The method of synthesizing the pigment derivative is not particularly limited. For example, when a sulfonyl group is introduced as a polar group into an azo pigment, a pigment in which a sulfonyl group is introduced into an azo pigment can be obtained by adding fuming sulfuric acid, concentrated sulfuric acid, or the like to a pigmentdispersed solution, heating the mixture to 60°C or more and 200°C or less, stirring the mixture, and then removing volatile components.

Examples of commercially available pigment derivatives include Solsperse 5000S, Solsperse 12000S, and Solsperse 22000 (manufactured by Lubrizol).

The synergist (D) may be an aqueous dye having an acidic group or a basic group.

Examples of the acidic group include carboxyl group, sulfonyl group, and phosphate group. Among these, sulfonyl group is preferable.

Examples of the basic group include amino groups and imino groups.

Examples of the aqueous dye include C.I. Acid Yellow 3, C.I. Acid Yellow 11, C.I. Acid Yellow 23, Direct Red 21, and the like.

The content of the synergist (D) is preferably 1% by mass or more and 10% by mass or less and more preferably 2% by mass or more and 8% by mass or less based on the total mass of the pigment (B). When the content is 1% by mass or more, the dispersion stability of the ink can be further improved. When the content is 10% by mass or less, the ratio of the pigment can be increased, and the color fluctuation of the cured film can be further suppressed.

### 1-5. Gelling agent (E)

The ink according to the present embodiment may include a gelling agent (E).

The gelling agent (E) causes the ink to be solated when the ink is heated and to be gelled at around room temperature. Specifically, the gelling agent can cause the ink to be solated when the ink temperature is 80°C, and can cause the ink to be gelled when the ink temperature is 25°C. Thus, the ink that has been heated and turned into a sol can be ejected from an inkjet head, and the ink that has landed on a recording medium and been cooled and turned into a gel can be temporarily solidified to enhance the pinning property of the ink. When the ink landed on the recording medium is gelated and pinned, the wetting and spreading of the ink is suppressed, and adjacent dots are less likely to become one dot. Therefore, it is possible to form a higher definition pattern on the circuit board.

The gelling agent (E) is preferably a compound that dissolves in the active ray-polymerizable compound contained in the ink at a temperature higher than the gelation temperature of the ink and crystallizes in the ink at a temperature equal to or lower than the gelation temperature of the ink. Here, the "gelation temperature" means a temperature at which the viscosity of the ink suddenly changes due to the phase transition of the ink from sol to gel when the ink which is solated or liquefied by heating is cooled. Specifically, while cooling the solated or liquefied ink while measuring the viscosity thereof with a rheometer (e.g., MCR300 manufactured by Anton Paar GmbH), the temperature at which the viscosity rapidly increases can be defined as the gelation temperature of the ink.

It is preferable that the gelling agent (E) is crystallized in the ink at a temperature equal to or lower than the gelation temperature of the ink to form a structure in which the radically polymerizable compound is contained in a three dimensional space formed by the gelling agent crystallized in a plate shape (such a structure is hereinafter referred to as "card house structure"). When the card house structure is formed, a liquid active ray-polymerizable compound is held in the space, and thus dots formed by adhesion of an ink to a recording medium are less likely to wet and spread, further enhancing the pinning property of the ink. Thus, dots formed by adhesion of the ink to the recording medium are unlikely to coalesce with each other.

In addition, according to the new findings of the present inventors, when an active ray-polymerizable compound having a ClogP value of 4 or more and 7 or less is used in combination with a gelling agent, color fluctuation of the cured film due to environmental changes can be suppressed. It is considered that this is because when the ClpgP value is 4 or more and 7 or less, the dissolution stabilization of the gelling agent is improved, a desired card house structure can be formed, and the active ray-polymerizable compound is held in the card house structure.

From the viewpoint of easily forming the card house structure, it is preferable that the active ray-polymerizable compound and the gelling agent (E) dissolved in the ink are compatible with each other.

Examples of the gelling agent that can more easily form a card house structure by crystallization include aliphatic ketones, aliphatic esters, petroleum-based waxes, plant-based waxes, animal-based waxes, mineral-based waxes, hydrogenated castor oil, modified waxes, higher fatty acids, higher alcohols, hydroxystearic acid, fatty acid amides including N-substituted fatty acid amides and special fatty acid amides, higher amines, sucrose fatty acid esters, synthetic waxes, dibenzylidene sorbitol, dimer acid, and dimer diol.

Examples of the aliphatic ketone include dilignoceryl ketone, dibehenyl ketone, distearyl ketone, dieicosyl ketone, dipalmityl ketone, dilauryl ketone, dimyristyl ketone, myristyl palmityl ketone, and palmityl stearyl ketone.

Examples of the aliphatic ester include fatty acid esters of monoalcohols such as behenyl behenate, icosyl icosanoate, stearyl stearate, palmityl stearate, myristyl myristate, cetyl myristate, and oleyl palmitate; and fatty acid esters of polyhydric alcohols such as glycerin fatty acid ester, sorbitan fatty acid ester, propylene glycol fatty acid ester, ethylene glycol fatty acid ester, and polyoxyethylene fatty acid ester.

Nihon Emulsion Co., Ltd.Examples of commercially available products of the aliphatic ester include EMALEX series (manufactured by Nippon Emulsion Co., Ltd. ("EMALEX" is a registered trade mark of the company)), RIKEMAL series and POEM series (manufactured by Riken Vitamin Co., Ltd. ("RIKEMAL" and "POEM" are both registered trade marks of the company)).

Examples of the higher fatty acid include behenic acid, arachidic acid, stearic acid, palmitic acid, myristic acid, lauric acid, oleic acid, and erucic acid.

Examples of the higher alcohol include stearyl alcohol and behenyl alcohol.

Among these, from the viewpoint of further improving the pinning property, the gelling agent is preferably an aliphatic ketone, an aliphatic ester, a higher fatty acid, or a higher alcohol, more preferably an aliphatic ketone represented by the following general formula (G1) or an aliphatic ester represented by the following general formula (G2). Only one type of gelling agent (E) may be contained, or two or more types of gelling agent (E) may be contained in combination.

General formula (G1): Rₐ-CO-R_{b}

General formula (G2): R_{c}-COO-R_{d}

In general formula (G1), Rₐ and R_{b} independently represent a linear hydrocarbon group which has 12 or more and 26 or less carbon atoms and may have a branched chain, and in general formula (G2), R_{c} and R_{d} independently represent a linear hydrocarbon group which has 12 or more and 26 or less carbon atoms and may have a branched chain.

In general formulae (G1) and (G2), when the number of carbon atoms of Rₐ to R_{d} is 12 or more, the crystallinity of the gelling agent represented by general formula (G1) and general formula (G2) is further enhanced, and a more sufficient space is generated in the card house structure. Therefore, the active ray-polymerizable compound (A) is more likely to be sufficiently included in the space, and the pinning property of the ink is improved.

In addition, when the number of carbon atoms of Rₐ to R_{d} is 26 or less, it is possible to suppress the melting points of the gelling agent represented by general formula (G1) and general formula (G2) from excessively increasing. Thus, the solation temperature of the ink containing a gelling agent is not excessively increased, and the ink can be ejected while the heating temperature of the ink is lowered.

Examples of the aliphatic ketone represented by general formula (G1) include: dilignoceryl ketone (number of carbon atoms: 23-24), dibehenyl ketone (number of carbon atoms: 21-22), distearyl ketone (number of carbon atoms: 17-18), dieicosyl ketone (number of carbon atoms: 19-20), dipalmityl ketone (number of carbon atoms: 15-16), dimyristyl ketone (number of carbon atoms: 13-14), dilauryl ketone (number of carbon atoms: 11-12), lauryl myristyl ketone (number of carbon atoms: 11-14), lauryl palmityl ketone (11-16), myristyl palmityl ketone (13-16), myristyl stearyl ketone (13-18), myristyl behenyl ketone (13-22), palmityl stearyl ketone (15-18), valmityl behenyl ketone (15-22), stearyl behenyl ketone (17-22), and the like. The number of carbon atoms in the above parentheses represents the number of carbon atoms of each of two hydrocarbon groups separated by a carbonyl group.

Examples of commercially available products of the compound represented by general formula (G1) include 18-Pentatriacontanon and Hentriacontan -16-on (all manufactured by Alfa Aeser), and KAO WAX T1 (manufactured by Kao Corporation).

Examples of the aliphatic ester represented by general formula (G2) include: behenyl behenate (carbon number: 21-22), icosyl icosanoate (number of carbon atoms: 19-20), stearyl stearate (number of carbon atoms: 17-18), palmityl stearate (number of carbon atoms: 17-16), lauryl stearate (number of carbon atoms: 17-12), cetyl palmitate (number of carbon atoms: 15-16), stearyl palmitate (number of carbon atoms: 15-18), myristyl myristate (number of carbon atoms: 13-14), cetyl myristate (number of carbon atoms: 13-16), octyldodecyl myristate (number of carbon atoms: 13-20), stearyl oleate (number of carbon atoms: 17-18), stearyl erucate (number of carbon atoms: 21-18), stearyl linoleate (number of carbon atoms: 17-18), behenyl oleate (number of carbon atoms: 18-22) and arachidyl linoleate (number of carbon atoms: 17-20), and the like. The number of carbon atoms in the above parentheses represents the number of carbon atoms of each of the two hydrocarbon groups separated by the ester group.

Examples of commercially available products of the aliphatic ester represented by the general formula (G2) include Unister M-2222SL, Spermaceti, Nissan Electol WEP-2 and Nissan Electol WEP-3 (all manufactured by NOF Corporation, "Unister" and "Nissan Electol" are registered trademarks of the company), Exepearl SS and Exepearl MY-M (all manufactured by Kao Corporation, "Exepearl" is a registered trademark of the company), Emalex CC-18 and Emalex CC-10 (manufactured by Nippon Emulsion Co., Ltd., "Emalex" is a registered trademark of the company), and Amreps PC (manufactured by Higher Alcohol Industries Co., Ltd., "Amreps" is a registered trademark of the company). These commercially available products are often mixtures of two or more types, and therefore, may be separated and purified as necessary to be contained in an ink.

The content of the gelling agent (E) is preferably 1% by mass or more and 10% by mass or less, more preferably 2% by mass or more and 8% by mass or less, and still more preferably 3% by mass or more and 7% by mass or less based on the total mass of the ink. When the content is 1% by mass or more, the pinning property of the ink can be further improved, and when the content is 10% by mass or less, the solubility in the active ray-polymerizable compound can be further increased.

### 1-6. Polymerization initiator (F)

In the present embodiment, the ink may contain a polymerization initiator.

The polymerization initiator is a compound that initiates polymerization and crosslinking of the active ray-polymerizable compound by irradiation with active rays. Note that the ink does not have to contain a polymerization initiator in a case where polymerization and crosslinking of the active ray-polymerizable compound can be initiated without a polymerization initiator, such as a case where the ink is cured by irradiation with electron beams.

The polymerization initiator (F) can be a radical polymerization initiator when the ink contains a radically polymerizable compound. Examples of the radical polymerization initiator include an intramolecular bond cleavage type radical polymerization initiator and an intramolecular hydrogen abstraction type radical polymerization initiator.

Examples of the intramolecular bond cleavage type radical polymerization initiator include acetophenone-based initiators such as diethoxyacetophenone, 2-hydroxy-2-methyl-1-phenylpropan-1-one, benzyldimethylketal, 1-(4-isopropylphenyl)-2-hydroxy-2-methylpropan-1-one, 4-(2-hydroxyethoxy) phenyl-(2-hydroxy-2-propyl) ketone, 1-hydroxycyclohexyl-phenylketone, 2-methyl-2-morpholino (4-methylthiophenyl) propan-1-one and 2-benzyl-2-dimethylamino-1-(4-morpholinophenyl)-butanone; benzoin-based initiators such as benzoin, benzoin methyl ether and benzoin isopropyl ether; acylphosphine oxide-based initiators such as 2,4,6-trimethylbenzoin diphenylphosphine oxides; benzyl and methylphenyl glyoxy esters; and the like.

Examples of the intramolecular hydrogen-abstraction type radical polymerization initiator include benzophenone-based initiators such as benzophenon, methyl o-benzoylbenzoate, 4-phenylbenzophenone, 4,4'-dichlorobenzophenone, hydroxybenzophenone, 4-benzoyl-4'-methyl-diphenyl sulfide, acrylated benzophenon, 3,3',4,4'-tetra (t-butylperoxycarbonyl) benzophenon, and 3,3'-dimethyl-4-methoxybenzophenone; thioxanthone-based initiators such as 2-isopropylthioxanthone, 2,4-dimethylthioxanthone, 2,4-diethylthioxanthone, and 2,4-dichlorothioxanthone; aminobenzophenone-based initiators such as Michler's ketone and 4,4'-diethylaminobenzophenone; 10-butyl-2-chloroacridone, 2-ethylanthraquinone, 9,10-phenanthrenequinone, and camphorquinone.

The content of the polymerization initiator (F) is preferably 1% by mass or more and 10% by mass or less and more preferably 2% by mass or more and 8% by mass or less based on the total mass of the ink.

### 1-7. Other components

The ink according to the present embodiment may further contain other components such as a surfactant, a polymerization inhibitor, and a humectant, within a range in which the effect of the present invention is exhibited.

Examples of the surfactant include anionic surfactants such as dialkylsulfosuccinates, alkylnaphthalenesulfonates, and fatty acid salts; nonionic surfactants such as polyoxyethylene alkyl ethers, polyoxyethylene alkyl allyl ethers, acetylene glycols, and polyoxyethylene-polyoxypropylene block copolymers; cationic surfactants such as alkylamine salts and quaternary ammonium salts; and silicone-based and fluorine-based surfactants.

Examples of commercially available silicone-based surfactants include Tego rad 2250 (manufactured by Evonik), KF 351A, KF 352A, KF 642, and X-22-4272; (manufactured by Shin-Etsu Chemical Co., Ltd), BYK307, BYK345, BYK347, and BYK348 (manufactured by BYK- Chemie GmbH ("BYK" is a registered trade mark of the company)), TSF4452 (manufactured by Momentive Performance Materials Inc), and the like.

Examples of commercially available products of fluorosurfactants include Megafac F (manufactured by DIC Corporation ("Megafac" is a registered trade mark of the company)), Surflon (manufactured by AGC Pure Chemical Co., Ltd. ("Surflon" is a registered trade mark of the company)), Fluorad FC (manufactured by 3M Corporation ("Fluorad" is a registered trade mark of the company)), Monflor (manufactured by Imperial Chemical Industries, Inc), Zonyls (manufactured by E.I. du Pont de Nemours and Company), Licowet VPF (manufactured by Lubewerke Hoechst), and FTERGENT (manufactured by Neos Co., Ltd. ("FTERGENT" is a registered trade mark of the company)).

The content of the surfactant based on the total mass of the ink is not particularly limited as long as the effects of the invention are exhibited, but can be set to, for example, 0.001% by mass or more and less than 1.0% by mass.

Examples of the polymerization inhibitor include N-oxyl-based polymerization inhibitors, phenol-based polymerization inhibitors, quinone-based polymerization inhibitors, amine-based polymerization inhibitors, and dithiocarbamate copper-based polymerization inhibitors. Only one type of polymerization inhibitor may be contained in the ink, or two or more type of polymerization inhibitor may be contained in combination.

Examples of the N-oxyl-based polymerization inhibitor include 4-hydroxy-2,2,6,6-tetramethylpiperidine-N-oxyl (TEMPO), 4-hydroxy-2,2,6,6-tetramethyl-piperidine-N-oxyl, 4-oxo-2,2,6,6-tetramethyl-piperidine-N-oxyl, 4-methoxy-2,2,6,6-tetramethyl-piperidine-N-oxyl, 4-acetoxy-2,2,6,6-tetramethyl-piperidine-N-oxyl, and the like. Examples of commercially available products of the N-oxyl-based polymerization inhibitor include Irgastab UV10 (manufactured by BASF ("Irgastab" is a registered trade mark of the company)).

Examples of the phenol-based polymerization inhibitor include 2,6-di-tert-butylphenol, 2,4-di-tert-butylphenol, 2-tert-butyl 4,6-dimethylphenol, 2,6-di-tert-butyl-4-methylphenol, 2,4,6-tri-tert-butylphenol, 2,6-di-t-butyl-p-cresol (butylated hydroxytoluene: BHT), 4-methoxyphenol, 2-methoxy-4-methylphenol and the like.

Examples of the quinone-based polymerization inhibitor include hydroquinones, methoxyhydroquinones, benzoquinones, 1,4-naphthoquinones, and p-tert-butylcatechol.

Examples of the amine-based polymerization inhibitor include alkylated diphenylamine, N,N'-diphenyl-p-phenylenediamine, and phenothiazine.

Examples of the copper dithiocarbamate-based polymerization inhibitor include copper dimethyldithiocarbamate, copper diethyldithiocarbamate, copper dibutyldithiocarbamate, and the like.

The content of the polymerization inhibitor is not particularly limited as long as the effect of the present invention is exhibited.

### 1-8. Physical Properties

The ink according to the present embodiment has a halogen content in the ink of 900 ppm or less. As used herein, the term "halogen content" refers to the content of halogen element in an ink as measured by flask combustion method.

As described above, when the halogen content in the ink is 900 ppm or less, precipitation of an inorganic salt in the ink can be suppressed, and a decrease in ejection stability can be suppressed. From such a viewpoint, the halogen content is preferably 750 ppm or less, more preferably 500 ppm or less, still more preferably 300 ppm or less, and particularly preferably 200 ppm or less. The upper limit of the halogen content is not particularly limited and may be 0 ppm or more.

The measurement by the flask combustion method is performed, for example, by putting the inkjet resist ink into a combustion flask and burning the ink sample. Next, the gas generated by the combustion is absorbed in an absorbing liquid (hydrogen peroxide solution). This absorbing liquid is analyzed using ion chromatography to determine the halogen content [ppm].

The halogen content can be adjusted by the types and amounts of the pigment, the pigment dispersing agent, and the synergist contained in the ink.

When the ink does not contain a gelling agent, the viscosity of the ink at 40°C is preferably 7 mPa·s or more and 15 mPa·s or less, and more preferably 8 mPa·s or more and 13 mPa·s or less. When the viscosity is within the above range, the ejection stability of the ink can be further improved.

When the ink contains a gelling agent, the viscosity of the ink at 80°C is preferably 3 mPa·s or more and 20 mPa·s or less, and more preferably in the range of 7 to 9 mPa·s, from the viewpoint of further enhancing the ejection property from the inkjet head. In addition, from the viewpoint of sufficiently gelling the ink when the ink lands and is cooled to room temperature, the viscosity of the inkjet resist ink at 25°C is preferably 1.0Pa·s or more and 1.0 × 10⁴ Pa·s or less.

When the ink contains a gelling agent, the ink preferably undergoes a sol-gel phase transition at a temperature of 40°C or more and less than 100°C. The gelation temperature of the ink is preferably 40°C or more and 70°C or less. When the gelation temperature of the ink is 40°C or higher, the ink rapidly gels after landing on a recording medium, so that the pinning property becomes higher. When the gelation temperature of the ink is 70°C or lower, the ink is less likely to be gelled at the time of ejecting the inkjet resist ink from an inkjet head in which the ink temperature is usually about 80°C, and thus the ink can be ejected more stably.

The viscosity at 80°C, the viscosity at 25°C, and the gelation temperature of the inkjet resist ink can be determined by measuring a temperature change in the dynamic viscoelasticity of the ink with a rheometer (e.g., a stress control type rheometer, Physica MCR series, manufactured by Anton Paar). Specifically, a temperature change curve of viscosity is obtained when the ink is heated to 100°C and cooled to 25°C under conditions of a shear rate of 11.7 (1/s) and a temperature decrease rate of 0.1°C/s. The viscosity at 80°C and the viscosity at 25°C can be determined by reading the viscosities at 80°C and 25°C, respectively, in the viscosity-temperature change curve. The gelation temperature can be determined as a temperature at which the viscosity becomes 200 mPa·s in a temperature change curve of viscosity.

When the ink contains a gelling agent, the viscosity (hereinafter, also referred to as "shear strain viscosity") of the ink at 25°C, with a strain of 5% as a shear strain, and an angular frequency of 10 radian/s is preferably 1.0 Pa·s or more and 1.0 × 10⁴Pa·s or less, more preferably 1.0 Pa·s or more and 1.0 × 10² Pa·s or less, and still more preferably 1.0 Pa·s or more and 1.0 × 10 Pa·s or less. When the viscosity is 1.0 Pa·s or more, the pinning property of the ink can be further enhanced, and when the viscosity is 1.0 × 10⁴ Pa·s or less, the ejection stability can be further enhanced.

The shear strain viscosity can be measured by changing the conditions of a shearing rate of 11.7 (1/s) to conditions of a strain of 5% and an angular frequency of 10 radian/s in the method for measuring the viscosity of the inkjet resist ink described above.

### 1-8. Method for preparing inkjet resist ink

The ink according to the present embodiment can be prepared by mixing the components described above. At this time, in order to increase the solubility of each component, it is preferable to mix while heating.

Note that a pigment dispersion liquid containing the pigment and the pigment dispersing agent may be prepared in advance, and the remaining components may be added thereto and mixed. Also at this time, in order to increase the solubility of the pigment dispersing agent and the like, it is preferable to prepare the pigment dispersion by mixing the pigment, the dispersant, and the like while heating.

### 2. Method for forming cured film

The method for forming a cured film according to the present embodiment includes a step of applying the above-described active ray-curable inkjet resist ink onto a printed wiring board, and a step of irradiating the applied inkjet resist ink with active ray.

### 2-1. Step of applying ink

In this step, the above-described inkjet resist ink is applied by an inkjet method to positions on the printed wiring board where a pattern is to be formed.

The method of ejection from the inkjet head may be either an on-demand method or a continuous method. The inkjet head of the on-demand system may be any of electro-mechanical transduction systems such as a single cavity type, a double cavity type, a bender type, a piston type, a share mode type, and a shared wall type, and electrothermal transduction systems such as a thermal inkjet type and a bubble jet ("bubble jet" is a registered trademark of Canon Inc) type.

The temperature of the ink when the ink is filled in the inkjet head is preferably set to 40°C or more and 100°C or less, and more preferably set to 40°C or more and 90°C or less, from the viewpoint of further enhancing the ejection property from the inkjet head.

In particular, when the ink contains a gelling agent, the temperature of the ink when filled in the inkjet head is preferably set to the gelling temperature of the ink + 10°C or more and the gelling temperature + 30°C or less because the droplets of the ink are discharged from the inkjet head in a heated and solated state. When the temperature of the active ray-curable ink in the inkjet head is the gelation temperature + 10°C or more, a reduction in ejection property caused by gelation of the ink in the inkjet head or on the nozzle surface is less likely to occur. On the other hand, when the temperature of the ink in the inkjet head is the gelation temperature + 30°C or less, deterioration of the components due to a high temperature is less likely to occur.

The method of heating the ink is not particularly limited. For example, at least any one of an ink supply system such as an ink tank, a supply pipe, and a front chamber ink tank immediately before the head, a pipe with a filter, a piezo head, and the like constituting the head carriage can be heated by a panel heater, a ribbon heater, heat-retaining water, and the like.

From the viewpoint of forming a finer pattern while increasing the pattern forming speed, the droplet amount of the ink to be ejected is preferably, 3.0pL or more and 9.0 pL or less and .

As the printed wiring board to which the ink is applied, a printed wiring board in which a conductive film such as a copper foil is formed on a base substrate can be used. Examples of the base substrate includes a rigid substrate and a flexible substrate.

Examples of the rigid substrate include a paper phenol substrate, a paper epoxy substrate, a glass epoxy substrate, a glass polyimide substrate, a Teflon (R) substrate, a PPO substrate, and a composite base epoxy base material.

Examples of the material for the flexible substrate include a PET film and a polyimide film.

### 2-2. Step of irradiating with actinic rays

In this step, the ink applied onto the substrate is irradiated with active rays to cure the ink.

The active rays can be selected from electron beam, ultraviolet, α rays, γ rays, And X-rays, and the like, but are preferably ultraviolet rays or electron beams. The ultraviolet rays are preferably light having a peak wavelength in a range of 360 nm to 410 nm inclusive. Furthermore, the ultraviolet rays are preferably emitted from an LED light source. Since an LED has less radiant heat as compared with a conventional light source (for example, a metal halide lamp or the like), by using the LED, an ink is less likely to be melted at the time of irradiation with active rays, and gloss unevenness or the like is less likely to be generated.

Note that when the cured film forming method according to the present embodiment further includes a heating to cure step described later, the ink may be only temporarily cured by irradiation with active rays in this step. Here, the term "pre-curing" refers to partially curing the ink to such an extent that the ink droplet applied to the substrate does not move and deform.

### 2-3. Step of heating to cure

The cured film forming method according to the present embodiment may further include a step of heating to cure the ink having been irradiated with active rays. In this step, the ink is further cured by heating the ink on the substrate after the step of irradiating with active rays.

This step can further improve the curability of the cured film to be formed. This makes it possible to further improve the adhesion of the cured film to the printed wiring board and the heat resistance.

The method for heating the ink on the substrate is not particularly limited, and for example, an oven can be used.

The heating temperature of the ink is not particularly limited as long as the ink can be thermally cured, but is preferably 140°C or more and 180°C or less. Furthermore, the heating time of the ink is preferably 30 minutes or more and 120 minutes or less, more preferably 30 minutes or more and 60 minutes or less.

### 3. Cured film

The cured film according to the present embodiment is formed by curing the above-described active ray-curable inkjet resist ink.

The cured film can be formed by the above-described cured film forming method.

The color of the cured film is not particularly limited as long as it is a color formed using a red pigment, and examples thereof include red, blue, green, orange, purple, and black. From the viewpoint of suppressing color variation of the cured film after high-temperature treatment, the color is preferably black.

### 4. Printed wiring board

The printed wiring board according to the present embodiment has the above-described cured film on a substrate.

The type of the printed wiring board on which the cured film is formed may be the same as that described in the method for forming a cured film.

### 5. Electronic device

An electronic apparatus according to the present embodiment includes the above-described printed wiring board.

Examples of the electronic device include information devices such as mobile phones, personal computers, and smartphones, household electrical appliances such as refrigerators, washing machines, and microwave ovens, medical devices, and industrial robots.

### Examples

Hereinafter, the present invention will be specifically described with reference to Examples, but the scope of the present invention is not limited to the description of Examples.

### 1. Preparation of inkjet resist inks AA1 to AA11

### 1-1. Preparation of pigment dispersion liquid

Into a stainless steel beaker, 7.0 parts by mass of a pigment dispersing agent C-1 (BYK-JET-9151, manufactured by BYK) and 77.0 parts by mass of dipropylene glycol diacrylate as a dispersion medium were introduced, and the inside of the beaker was stirred for 1 hour while heating on a hot plate set to 65°C, and then the cooling was performed to room temperature. After the cooling, 16.0 parts by mass of magenta pigment B-M1 (inkjet magenta E5B02, manufactured by Craliant Co., Ltd) was added into the beaker. Next, the solution in the beakers was put in a glass bottle together with zirconia beads 200 g having diameters of 0.5 mm, the glass bottle was hermetically sealed, and a dispersion treatment was performed using a paint shaker (5400, manufactured by Red Devil). Thereafter, the zirconia beads were removed to produce a pigment dispersion liquid M1.

Pigment dispersion liquids M2 to M6, pigment dispersion liquids Y1 and Y2, pigment dispersion liquids Cy1 to Cy3, and a pigment dispersion liquid K were prepared in the same manner as the pigment dispersion liquid M1 except that the types and amounts of the pigment, the type and amount of the pigment dispersing agent, and the amount of the synergist added were changed as indicated in Table 1. Note that the numerical values of the compositions in Table 1 represent parts by mass.

The types of the pigments and the pigment dispersing agents used for the preparation of the pigment dispersion liquids are as follows.

### (Pigment)

B-M1: magenta pigment PV19 (inkjet magenta E5B02, manufactured by Craliant)
B-M2: magenta pigment PV19 (Fastogen Super Red BRZ, manufactured by DIC Corporation)
B-M3: magenta pigment PV19/PR122 (Sync Asia Magenta D4500J, manufactured by BASF)
B-Y: yellow pigment PY185 (Paliotol Yellow D1155, manufactured by BASF)
B-C: cyan pigment PB15:4 (Chromofine Blue 6332JC, Dainichiseika Color & Chemicals Mfg. Co., Ltd)
B-K: black pigment PB7 (Mitsubishi Carbon Black MA-7, manufactured by Mitsubishi Chemical Corporation)

### (Pigment dispersing agent)

C-1: BYK-JET-9151 (manufactured by BYK Japan KK, acid value: 8MG/KOH, amine value: 18mg/KOH)
C-2: EFKA7701 (manufactured by BASF, acid value: -, amine value: 40mg/KOH)
C-3: Solsperse 36000 (manufactured by Lubrizol Corporation, acid value: 45mg/koh, amine value: -)

The acid values and the amine values of the pigment dispersing agents C-1 to C-3 were measured by the following methods.

### (Acid value)

A solution of 1 g of a pigment dispersing agent dissolved in 100 mL of methylisobutylketone (MIBK) was titrated potentiometrically with 0.01 mol/L solution of potassium methoxide-methylisobutylketone/methanol (volume ratio 4:1). Then, the amount of the solution required for neutralization was converted into a unit to determine the acid value of the pigment dispersing agent. Note that the potentiometric titration was performed with an automatic titrator (COM-1500, manufactured by HIRANUMA Co., Ltd).

### (Amine value)

A solution of the pigment dispersing agent 1 g in methylisobutylketone (MIBK) 100 mL was titrated potentiometrically with 0. 01 mol/L MIBK perchlorate solution. Then, the amount of the MIBK perchlorate solution required for neutralization was converted into a unit, and the amine value of the pigment dispersing agent was determined. Note that the potentiometric titration was performed with the same apparatus as used in the method of measuring the acid value.

### (Synergist)

### D: Solsperse22000 (manufactured by Lubrizol Corporation)

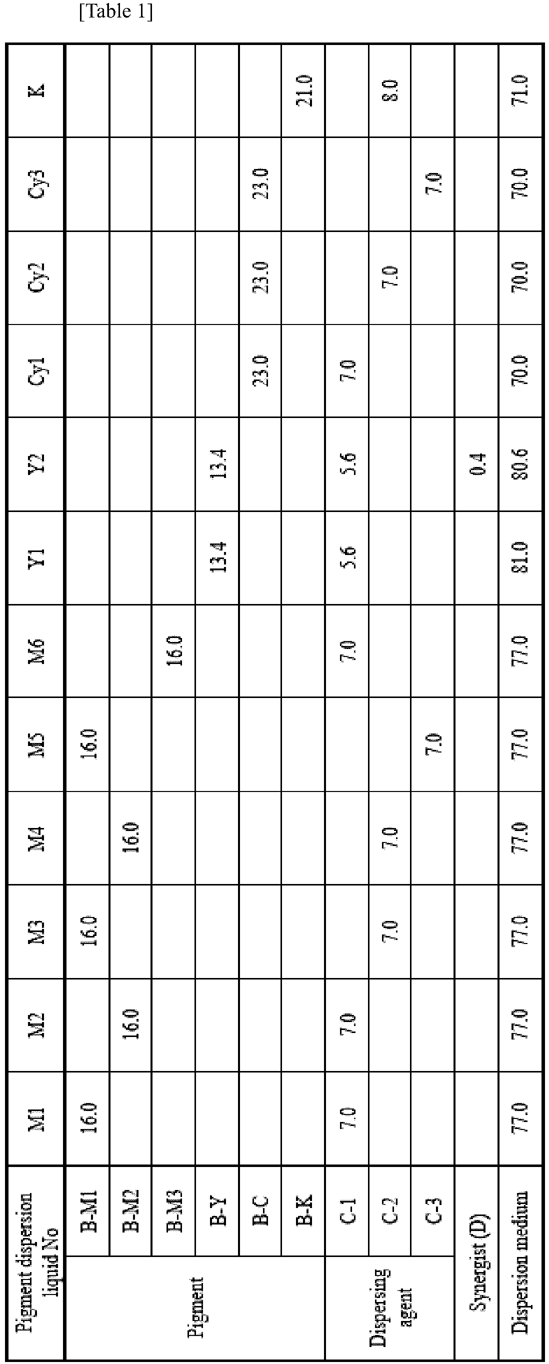

### 1-2. Preparation of inkjet resist ink

While stirring 2.2 parts by mass of the pigment dispersion liquid M1 and 1.8 parts by mass of the pigment dispersion liquid Y1, 20.0 parts by mass of the active ray-polymerizable compound A-1, 38.9 parts by mass of the active ray-polymerizable compound A-3, 33.0 parts by mass of the active ray-polymerizable compound A-4, 1.0 parts by mass of a photopolymerization initiator 1 (Irgacure TPO, manufactured by BASF), 3.0 parts by mass of a photopolymerization initiator 2 (Genocure ITX, manufactured by Rahn A.G.), and 0.1 parts by mass of a polymerization inhibitor (Irgastab UV10, manufactured by BASF) were added to prepare an ink composition. The obtained ink composition was filtered through a 3.0-µm membrane filter (manufactured by ADVANTECH) to obtain an inkjet resist ink AA1.

Inkjet resist inks AA2 to AA11 were obtained in the same manner as the inkjet resist ink AA1 except that the type and amount of the pigment dispersion liquid used were changed as indicated in Table 2. The numerical values of the compositions in Table 2 represent parts by mass.

The types of the active ray-polymerizable compounds used in the preparation of the inkjet resist inks AA2 to AAT11 are as follows.
A-1: o-phenylphenol EO acrylate (monofunctional, molecular weight: 268, ClogP value: 3.89).
A-2 : dipropylene glycol diacrylate (bifunctional, molecular weight: 242, ClogP value: 2.04)
A-3: tricyclodecane dimethanol diacrylate (bifunctional, molecular weight: 304, ClogP value: 4.69)
A-4: isobornyl acrylate (monofunctional, molecular weight: 208, ClogP value: 4.66)

### 1-3. Evaluation

### (Color of ink)

The colors of the obtained inkjet resist inks AA1 to AA11 were determined by visual observation.

### (Halogen content)

The inkjet resist ink AA1 was charged into a combustion flask and the ink sample was combusted. The generated gas was absorbed in aqueous hydrogen peroxide, and the absorption liquid was analyzed by ion chromatography to determine the halogen content [ppm]. The halogen contents of the inkjet resist inks AA2 to AA11 were determined in the same manner.

### (Particle diameter)

The average particle size of each of the pigments contained in the inkjet resist inks AA1 to AA 11 was measured by a dynamic light scattering method using a particle size distribution analyzer (Zetasizer Nano ZSP, manufactured by Malvern).

### (Pigment dispersion stability)

The inkjet resist inks AA1 to AA11 were each collected into an individual heat-resistant tube and stored in a thermostatic bath at 60°C for one month. The average particle diameter of the pigment particles contained in each inkjet resist ink after storage was measured in the same manner as described above. The difference (PB-PA) between the average particle diameter (PA) of the pigment particles before the storage in the thermostatic bath and the average particle diameter (PB) of the pigment particles after the storage was calculated, and the pigment dispersion stability was evaluated according to the following criteria.
∘ The difference in average particle diameter before and after storage is less than 7 nm
△ The difference in average particle diameter before and after storage is 7 nm or more but less than 15 nm
× The difference in average particle diameter before and after storage is 15 nm or more

### (Ejection stability of ink)

The inkjet resist inks AA1 to AA11 were each collected in individual containers and stored in a thermostatic bath at 25°C for 2 months. Each of the inkjet resist inks AA to AA11 after storage was loaded into an inkjet recording apparatus having an inkjet recording head. The inkjet recording head is driven by a piezoelectric inkjet (KM1800iSHC-C: manufactured by Konica Minolta Inc.: Resolution 600dpi). Using the piezo head, continuous ejection (driving) was performed under the conditions of a droplet amount of 3.5pL, a droplet speed of 7 m/s, an ejection rate of 440kHz, and a printing rate of 100%, and the number of nozzles that did not eject was counted after 1 minute, 5 minutes, and 10 minutes from the start of driving.
∘: The number of deficient nozzles is less than five
△: The number of deficient nozzles is five or more and less than 20
×: The number of deficient nozzles is 20 or more

The evaluation results are summarized in Table 2.

**[Table 2]**

| | | Present invention | Present invention | Present invention | Present invention | Present invention | Present invention | Present invention | Present invention | Present invention | Comparative example | Comparative example |
|---|---|---|---|---|---|---|---|---|---|---|---|---|
| Inkjet ink No | | AA1 | AA2 | AA3 | AA4 | AA5 | AA6 | AA7 | AA8 | AA9 | AA10 | AA11 |
| Active ray-polymerizable compound | A-1 | 20.0 | 20.0 | 20.0 | 20.0 | 20.0 | 20.0 | 20.0 | 20.0 | 20.0 | 20.0 | 20.0 |
| | A-2 | 38.9 | 38.9 | 36.9 | 38.9 | 36.9 | 38.9 | 38.9 | 37.9 | 38.9 | 38.9 | 38.9 |
| | A-3 | 33.0 | 33.0 | 33.0 | 33.0 | 33.0 | 33.0 | 33.0 | 33.0 | | 33.0 | 33.0 |
| | A-4 | | | | | | | | | 33.0 | | |
| Pigment dispersion liquid | M1 | 2.2 | 2.2 | | 1.2 | 1.6 | | | 2.2 | 2.2 | | |
| | M2 | | | 2.2 | | | | | | | | |
| | M3 | | | | | | 2.2 | | | | | |
| | M4 | | | | | | | 2.2 | | | | |
| | M5 | | | | | | | | | | 1.2 | |
| | M6 | | | | | | | | | | | 2.2 |
| | Y1 | 1.8 | | | | 1.6 | | | | 1.8 | | 1.8 |
| | Y2 | | 1.8 | 1.8 | | | 1.8 | 1.8 | | | | |
| | Cy1 | | | | 2.8 | 2.8 | | | | | | |
| | Cy2 | | | | | | | | 2.8 | | | |
| | Cy3 | | | | | | | | | | 2.8 | |
| Photopolymerization initiator 1 | | 1.0 | 1.0 | 1.0 | 1.0 | 1.0 | 1.0 | 1.0 | 1.0 | 1.0 | 1.0 | 1.0 |
| Photopolymerization initiator 2 | | 3.0 | 3.0 | 3.0 | 3.0 | 3.0 | 3.0 | 3.0 | 3.0 | 3.0 | 3.0 | 3.0 |
| Polymerization inhibitor | | 0.1 | 0.1 | 0.1 | 0.1 | 0.1 | 0.1 | 0.1 | 0.1 | 0.1 | 0.1 | 0.1 |
| Evaluation | Color | Red | Red | Red | Blue | Black | Red | Red | Blue | Red | Blue | Red |
| | Halogen amount | 11 | 11 | 137 | 14 | 18 | 11 | 11 | 14 | 11 | 11 | 1958 |
| | Particle diameter | 129 | 112 | 132 | 141 | 126 | 122 | 135 | 123 | 127 | 315 | 137 |
| | Pigment dispersion stability | Δ | ○ | ○ | ○ | ○ | ○ | ○ | ○ | Δ | × | Δ |
| | Ejection stability | ○ | ○ | ○ | ○ | ○ | ○ | ○ | ○ | Δ | × | × |

The inks AA1 to AA9 had satisfactory dispersion stabilities and ejection stabilities of the pigments. It is considered that this is because the amine value of the pigment dispersing agent contained in the ink is higher than the acid value thereof, thus enhancing the interaction between the pigment dispersing agent and the pigment and enhancing the dispersion stability of the pigment. In addition, it is considered that when the halogen content of the ink is 900 ppm or less, precipitation of an inorganic salt between the ink and a metal ion is suppressed, and thus the ejection stability is enhanced.

Furthermore, the dispersion stabilities were further enhanced in the ink AA2, AA3, AA6, and AA7. This is considered to be because the synergist was contained in the ink.

The ink AA1 was more stable in ejection than the ink AA9. This is probably because the compound having a ClogP value of 4 or more and 7 or less contained in the ink has a molecular weight of 300 or more and 1500 or less, so that nonvolatile matter due to volatilization of liquid components of the ink can be prevented from adhering to a nozzle.

On the other hand, the dispersion stability and ejection stability were not improved in the ink AA10, AA12, in which the amine value of the dispersing agent was lower than the acid value. Further, in the ink 900 ppm in which the halogen content of the ink was larger than that in the AA11, the ejection stabilities were not improved.

### 2. Preparation of inkjet resist inks BB1 to BB20

### 2-1. Pigment dispersion liquid

The pigment dispersion liquids M1 to M6, the pigment dispersion liquids Y1 and Y2, the pigment dispersion liquid C1, and the pigment dispersion liquid K, which are indicated in Table 1, were used.

### 2-2. Preparation of inkjet resist ink

While stirring 2.2 parts by mass of the pigment dispersion liquid M1 and 1.8 parts by mass of the pigment dispersion liquid Y1, 30.0 parts by mass of the active ray-polymerizable compound A-1, 16.9 parts by mass of the active ray-polymerizable compound A-2, 25.0 parts by mass of the active ray-polymerizable compound A-6, 20.0 parts by mass of the active ray-polymerizable compound A-7, 1.0 parts by mass of a photopolymerization initiator 1 (Irgacure TPO, manufactured by BASF), 3.0 parts by mass of a photopolymerization initiator 2 (Genocure ITX, manufactured by Rahn A.G.), and 0.1 parts by mass of a polymerization inhibitor (Irgastab UV10, manufactured by BASF) were added to prepare an ink composition. The obtained ink composition was filtered through a 3.0-µm membrane filter (manufactured by ADVANTECH) to obtain an inkjet resist ink B1.

Inkjet resist inks BB2 to BB20 were obtained in the same manner as the inkjet resist ink BB1 except that the type and amount of the pigment dispersion liquid and the type and amount of the active ray-polymerizable compound used were changed as indicated in Tables 3 to 6. Note that the numerical values and the compositions in Tables 3 to 6 represent parts by mass.

The types of the active ray-polymerizable compounds and the types of the gelling agents used in the preparation of the inkjet resist inks BB1 to BB20 are as follows.

### (Active ray-polymerizable compound)

A-1: o-phenylphenol EO acrylate (monofunctional, molecular weight: 268, ClogP value: 3.89)
A-2: dipropylene glycol diacrylate (bifunctional, molecular weight: 242, ClogP value: 2.04)
A-3: tricyclodecane dimethanol diacrylate (bifunctional, molecular weight: 304, ClogP value: 4.69)
A-5: nonylphenol 2PO modified acrylate (monofunctional, molecular weight: 390, ClogP value: 2.04)
A-6: propoxylated (3) neopentyl glycol diacrylate (bifunctional, molecular weight: 328, ClogP value: 3.33)
A-7: 4EO modified hexanediol diacrylate (bifunctional, molecular weight: 358, ClogP value: 2.49)
A-8: dipentaerythritol hexaacrylate (6 functional groups, molecular weight: 578, ClogP value: 5.08)
A-9: aliphatic urethane acrylate oligomer, (trifunctional, CN989, manufactured by Sartomer Company)
A-10: acrylate dendrimer, product of Miwon, SP1106 (18 functional groups, molecular weight: 1630)
A-11: a compound represented by the following formula (a) (trifunctional, molecular weight: 398, ClogP value: 2.98)

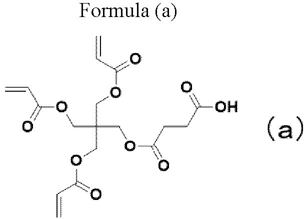

The viscosities at 25°C and the sol-gel phase transition temperatures of the prepared inkjet resist inks BB12 to BB18 were measured by the following methods.

Using a stress-controlled rheometer (Physica MCR series, manufactured by Anton Paar GmbH), each ink was heated to 100°C and cooled to 25°C under conditions of a shear rate of 11.7 (1/s) and a temperature lowering rate of 0.1°C/s, and a viscosity temperature change curve was obtained. Then, the viscosity at 80°C and the viscosity at 25°C were determined by reading the viscosity at 25°C on the viscosity temperature change curve. The sol-gel phase transition temperature was determined as a temperature at which the viscosity became 200 mPa·s on the viscosity temperature change curve.

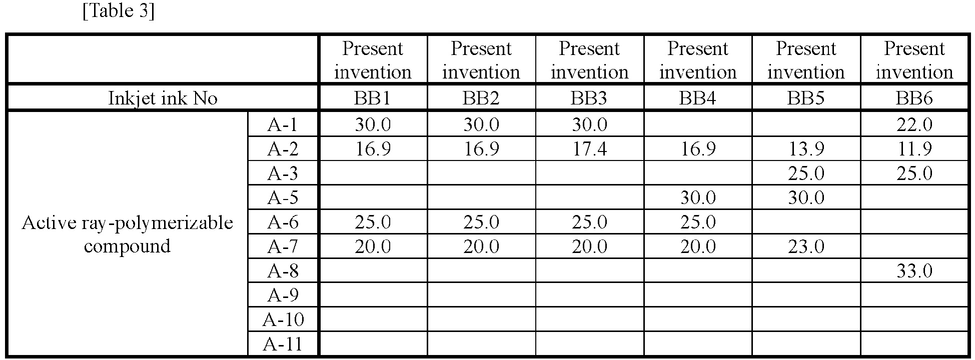

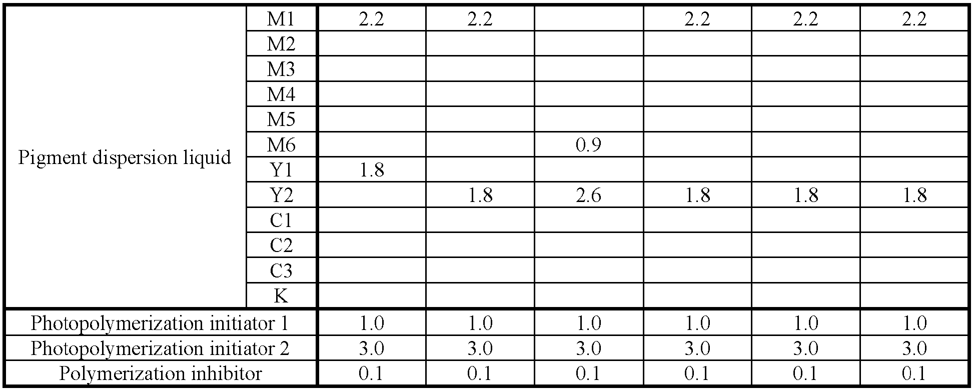

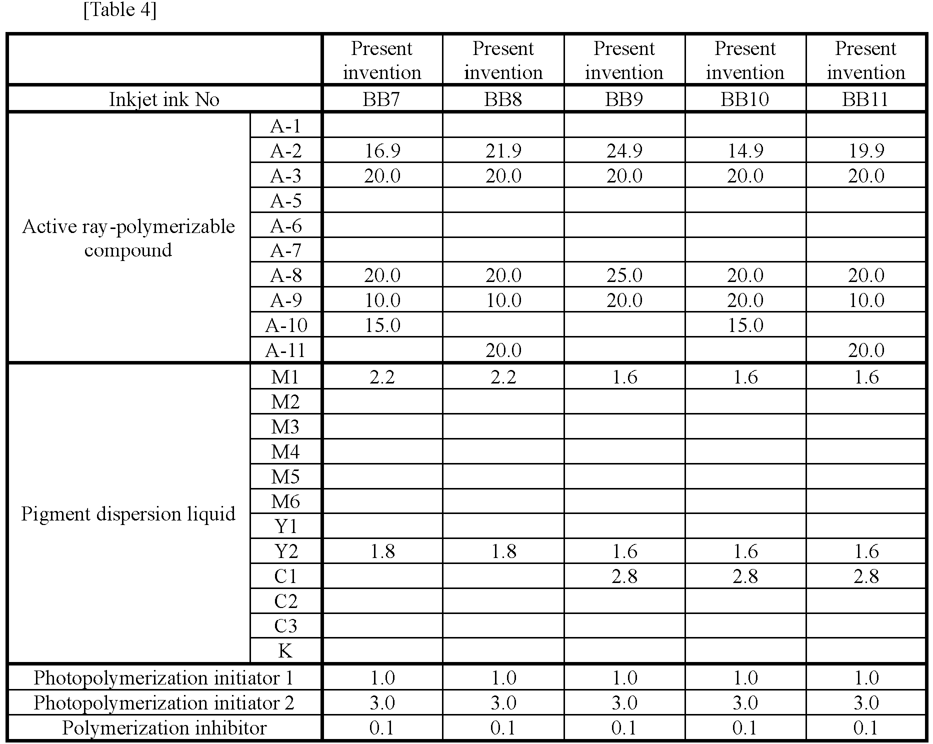

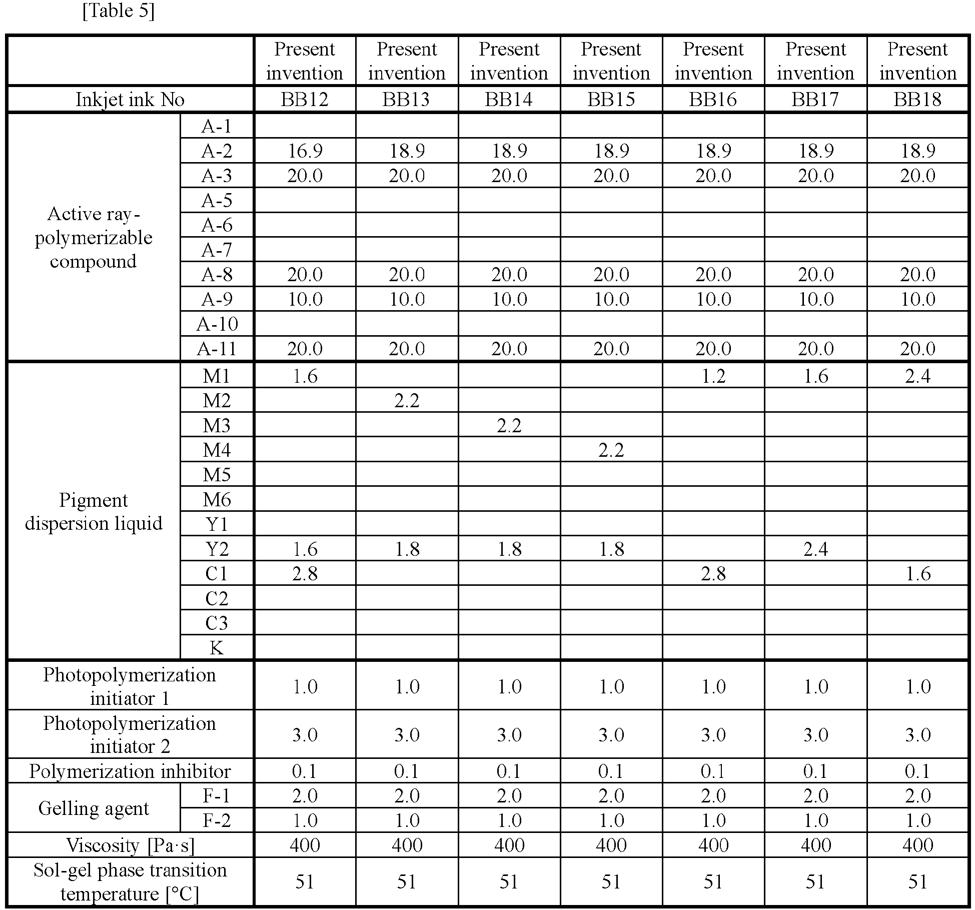

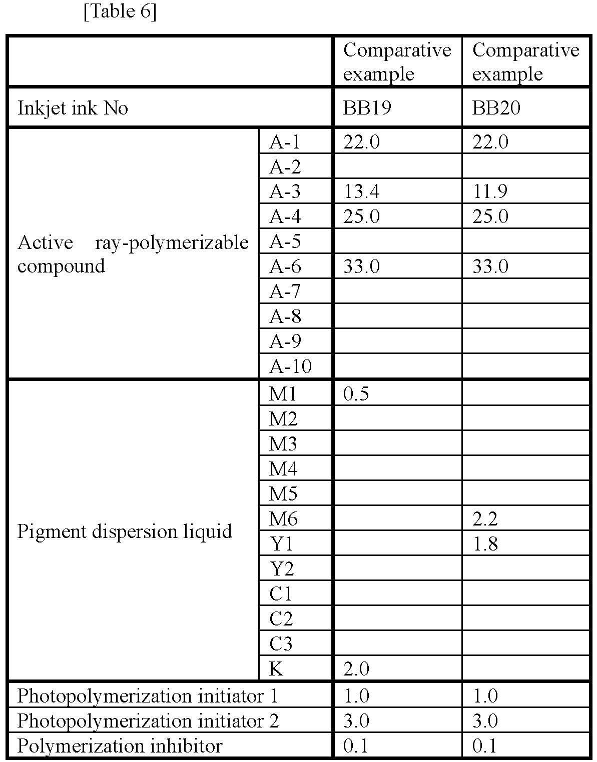

### 2-3. Pattern formation with inkjet resist ink

Two independently driven heads of a piezo-type inkjet head (KM1800iSHC-C, resolution 600dpi, manufactured by Konica Minolta, Inc.) were arranged such that the nozzles were alternately arranged, to produce an inkjet recording head with a nozzle row of 1200dpi. The head module was filled with inkjet resist ink BB1 from an ink tank storing the inkjet resist ink BB1 via an ink channel.

Next, a voltage was applied to the inkjet recording head such that the amount of droplets ejected became 6.0 pL, and in a size 20 mm × 50 mm, a 30-µm-thick solid pattern and a thin line pattern having a line and space of 100 µm and a line width of 30 µm were printed on a copper-clad laminate for a printed wiring board (FR4, thickness 6mm, size 1.150 mm × 95 m). During printing, the ink in the recording head was heated to 80°C with a built-in heater of the recording head.

The printed patterns were irradiated with light from an LED lamp (Fire Jet (TM) FJ100, manufactured by Phoseon Technology, Inc., wave length 395 nm) so that the intensity became 500 mJ/cm², to temporary cure the ink layer. Thereafter, the substrate was placed in an oven and heated at 150°C for 60 minutes to obtain a printed sample.

The same operation was performed on the inkjet resist inks BB2 to BB20.

### 2-4. Evaluation

### (Pigment dispersion stability)

Each of the inkjet resist inks BB1 to BB20 was collected in an individual heat-resistant tube and stored in a thermostatic bath at 60°C for one month. The average particle diameter of the pigment particles contained in each inkjet resist ink after storage was measured in the same manner as described above. The difference (PB-PA) between the average particle size (PA) of the pigment particles before the storage in the thermostatic bath and the average particle size (PB) of the pigment particles after the storage was calculated, and the pigment dispersion stability was evaluated according to the following criteria.
∘ The difference in average particle diameter before and after storage is less than 7 nm
△ The difference in average particle diameter before and after storage is 7 nm or more but less than 15 nm
× The difference in average particle diameter before and after storage is 15 nm or more

### (Color of coating film)

The color of the coating film of the formed solid pattern was visually observed and determined.

### (Halogen content)

The halogen content in the inkjet resist inks BB1 to BB20 was measured in the same manner as described above.

### (Ejection stability of ink)

The piezoelectric head was used to perform continuous ejection (driving) under the conditions of a droplet amount of 3.5 pl, a droplet speed of 7 m/s, an ejection rate of 40kHz, and a printing rate of 100%, and the number of nozzles that were not ejecting was counted 1 minute, 5 minutes, and 10 minutes after the start of driving.
∘: The number of deficient nozzles is less than five
△: The number of deficient nozzles is five or more and less than 20
×: The number of deficient nozzles is 20 or more

### (Thin-line reproducibility)

The formed thin line pattern was observed under a microscope (VHX-5000, manufactured by KEYENCE Corporation) at a magnification of 500, and the fine line reproducibility was evaluated according to the following criteria.
⊚ Lines are sharp, the line and space error is reproduced within ±10µm, and there is no scattering such as satellites
o Slight thickening or thinning of the lines can be seen, but the line and space error is reproduced in a range more than ±10 µm and ±20 µm or less
△: Thickening or thinning of the lines can be seen, and the line and space error is reproduced in a range more than ±20 µm and ±30 µm or less
×: The lines are uneven, the line and space error is more than ±30 µm, or there are areas where the lines are crushed and the spaces are filled

### (Solder heat resistance)

The substrate on which the above-described solid pattern was formed was immersed in a solder bath at 260°C for 10 seconds three times, then, in accordance with the JIS K5600-5-6: 1999's cross-cut method, cuts were made in the cured film in the form of a grid, and a pressure-sensitive adhesive tape was attached. The pressure-sensitive adhesive tape was peeled off, and the peeling state of the cured film from the substrate was observed to determine the adhesive residue rate. Here, the adhesive residue rate refers to a rate of the number of squares in which the cured film remains after the tape is peeled off to the number of squares formed by making the cuts. Based on the adhesive residue rate, the solder heat resistance was evaluated according to the following evaluation criteria.
⊚ The adhesive residue rate is 100%
∘ The adhesive residue rate is 90% or more and less than 100%
△ The adhesive residue rate is 70% or more and less than 90%
× The adhesive residue rate is less than 70%

### (Change in color tone of coating film after high-temperature treatment)

The substrate on which the solid pattern was formed was further placed in an oven and heated at 140°C for 60 minutes. The cured film of the solid pattern before and after the heating was measured with a colorimeter and visually observed, and the change in color tone was evaluated according to the following criteria.
⊚ The color difference ΔE* is less than 2, and no change in color tone is visually observed
∘ The color difference ΔE* is 2 or more and less than 3, and a slight change in color tone is visually observed
△: The color difference ΔE* is 3 or more and 5 or less, and a change in color tone is visually observed
× The color difference ΔE* is 5 or more, and the color tone is clearly different

### (Adhesion of coating film to base material after high-temperature treatment)

The substrate on which the solid pattern was formed was further placed in an oven and heated at 140°C for 60 minutes. The cured film after heating was cut in a grid pattern in accordance with the JIS K5600-5-6:1999's cross-cutting method, and an adhesive tape was attached thereto. The pressure-sensitive adhesive tape was peeled off, and the peeling state of the cured film from the substrate was observed to determine the adhesive residue rate. The adhesive residue rate can be determined in the same manner as in the evaluation of solder heat resistance. Based on the adhesive residue rate, the adhesion to a base material was evaluated according to the following criteria.
⊚ The adhesive residue rate is 100%
o The adhesive residue rate is 80% or more and less than 100%
△ The adhesive residue rate is 60% or more and less than 80%
× The adhesive residue rate is less than 60%

The evaluation results are summarized in Table 7.

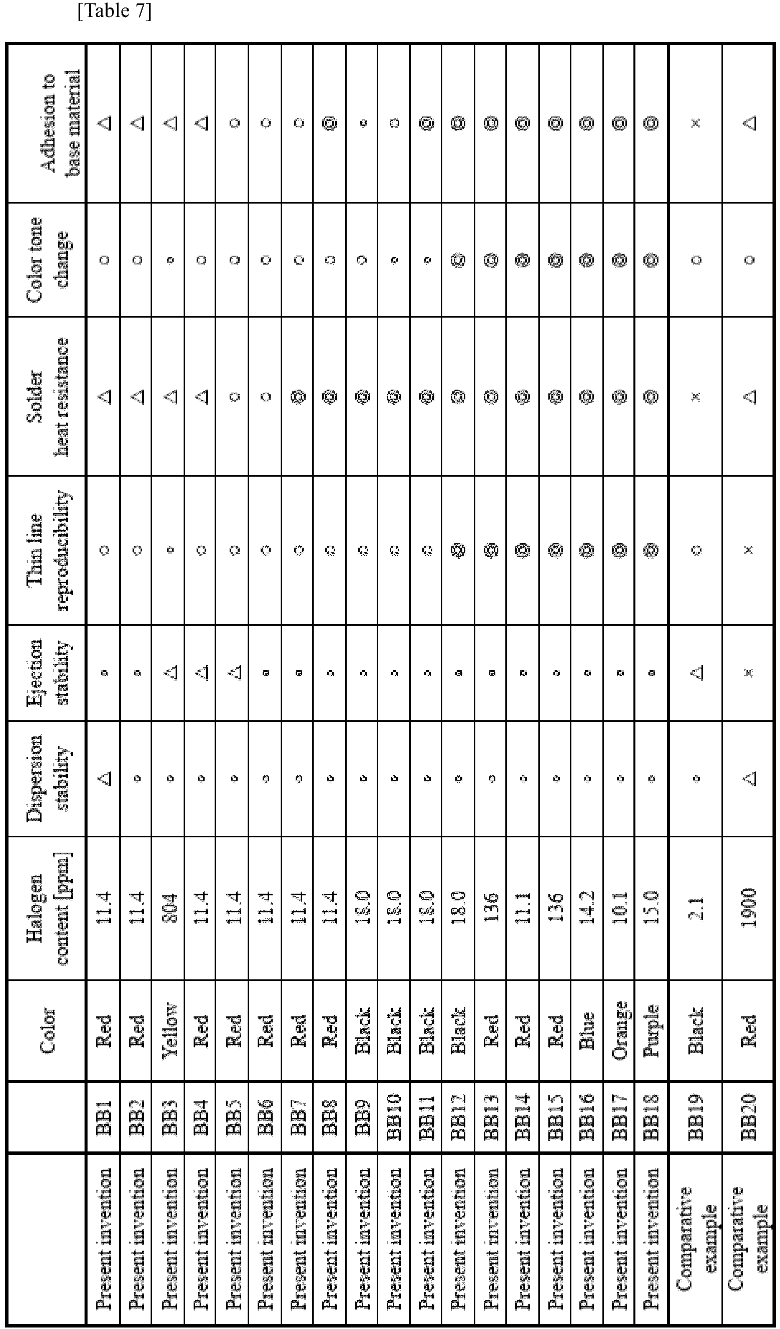

The inks BB1 to BB18 had satisfactory dispersion stabilities and ejection stabilities of the pigments. It is considered that this is because the amine value of the pigment dispersing agent contained in the ink is higher than the acid value thereof, thus enhancing the interaction between the pigment dispersing agent and the pigment and enhancing the dispersion stability of the pigment. In addition, it is considered that when the halogen content of the ink is 900 ppm or less, precipitation of an inorganic salt between the ink and a metal ion is suppressed, and thus the ejection stability is enhanced.

Furthermore, it was confirmed that even when the ink contained a red pigment, the color fluctuation of the cured film was suppressed.

The inks BB6 to BB18, in each of which the active ray-polymerizable compound in the ink contains a compound having three or more polymerizable groups, had improved solder resistance.

This application claims the benefit of Japanese Patent Application No. 2022-087986 filed on May 30, 2022. The contents described in the specification of the application and the drawings are all incorporated in the description of the present application.

### Industrial Applicability

The active ray-curable inkjet resist ink according to the present invention can improve the dispersion stability of the pigment and the ejection stability of the ink after long-term storage, can suppress the color fluctuation of the cured film even after high-temperature treatment, and can improve the adhesion of the cured film to the base material and the heat resistance. Therefore, the resist ink is useful for, for example, production of wiring boards.

## Claims

1. An active ray-curable inkjet resist ink, comprising:
an active ray-polymerizable compound (A); a pigment (B); and a pigment dispersing agent (C), wherein
the pigment (B) includes a red pigment (B1) having a maximum absorption wavelength of 480 nm or more and 600 nm or less and a pigment (B2) having a color different from that of the red pigment (B1),
the pigment dispersing agent (C) has an amine value and an acid value, the amine value being larger than the acid value, and
a halogen content in the active ray-curable inkjet resist ink is 900 ppm or less, and the active ray-curable inkjet resist ink is substantially free of a black inorganic pigment.

2. The active ray-curable inkjet resist ink according to claim 1, further comprising:
a synergist (D).

3. The active ray-curable inkjet resist ink according to claim 1 or 2, wherein a content of the black inorganic pigment is less than 0.01% by mass.

4. The active ray-curable inkjet resist ink according to claim 1 or 2, wherein:
the active ray-polymerizable compound (A) includes a compound (A1) having a ClogP value of 4.0 or more and 7.0 or less, and
a content of the compound (A1) is 10% by mass or more and 50% by mass or less based on a total mass of the active ray-curable inkjet resist ink.

5. The active ray-curable inkjet resist ink according to claim 4, wherein
the compound (A1) has a molecular weight of 300 or more and 1500 or less.

6. The active ray-curable inkjet resist ink according to claim 1 or 2, wherein
the active ray-polymerizable compound (A) includes a compound having three or more polymerizable groups.

7. The active ray-curable inkjet resist ink according to claim 1 or 2, wherein the active ray-polymerizable compound (A) includes a compound represented by a general formula (1) below or a salt thereof: 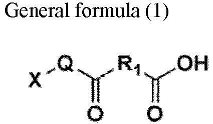 wherein R₁ represents an unsubstituted alkylene group having 1 to 6 carbon atoms, Q represents an oxygen atom or NR₂, R₂ represents a hydrogen atom, a substituted or unsubstituted alkyl group, or a substituted or unsubstituted aryl group, and X represents a structure derived from an alcohol or an amine and having at least one polymerizable group selected from the group consisting of a (meth)acryloyl group, an aryl group, and a vinyl group at a terminal of the structure.

8. The active ray-curable inkjet resist ink according to claim 1 or 2, further comprising:
a gelling agent (E).

9. The active ray-curable inkjet resist ink according to claim 8, wherein
the active ray-curable inkjet resist ink has a viscosity of 1.0 Pa·s or more and 1.0 × 10⁴ Pa·s or less at a temperature of 25°C, and undergoes a sol-gel phase transition at a temperature of 40°C or more and less than 100°C.

10. The active ray-curable inkjet resist ink according to claim 1 or 2, wherein
the halogen content in the active ray-curable inkjet resist ink is 300 ppm or less.

11. A method for forming a cured film, the method comprising:
applying the active ray-curable inkjet resist ink according to claim 1 or 2 onto a substrate; and
irradiating the applied active ray-curable inkjet resist ink with an active ray.

12. The method according to claim 11, further comprising:
heating to cure the active ray-curable inkjet resist ink having been irradiated with the active ray.

13. A cured film obtained by curing the active ray-curable inkjet resist ink according to claim 1 or 2.

14. A printed wiring board comprising:
the cured film according to claim 13.

15. An electronic device comprising:
the printed wiring board according to claim 14.
